# EUROPEAN PATENT SPECIFICATION

(11) **EP 4 651 194 B1**
(45) Date of publication and mention of the grant of the patent: **15.04.2026**
(21) Application number: 24218996.7
(22) Date of filing: 11.12.2024
(51) Int. Cl.: H01L 21/768, H01L 23/48, H10D 84/01, H10D 84/85, H01L 23/528

(54) **SEMICONDUCTOR DEVICE INCLUDING A THROUGH-SUBSTRATE VIA**
HALBLEITERANORDNUNG MIT EINER SUBSTRATDURCHKONTAKTIERUNG
DISPOSITIF SEMI-CONDUCTEUR COMPRENANT UNE CONNEXION VERTICALE TRAVERSANT LE SUBSTRAT

(30) Priority: 14.05.2024 KR 20240063245
(43) Date of publication of application: 19.11.2025
(73) Proprietor: Samsung Electronics Co., Ltd., Suwon-si, Gyeonggi-do 16677 (KR)
(72) Inventor: NAM, Yunsuk, 16677 Suwon-si, Gyeonggi-do (KR); PARK, Yoonbeom, 16677 Suwon-si, Gyeonggi-do (KR); KIM, Jinkyu, 16677 Suwon-si, Gyeonggi-do (KR); SHIN, Jaehoon, 16677 Suwon-si, Gyeonggi-do (KR); SHIN, Haein, 16677 Suwon-si, Gyeonggi-do (KR); LEE, Yongwoo, 16677 Suwon-si, Gyeonggi-do (KR); FUKUTOME, Hidenobu, 16677 Suwon-si, Gyeonggi-do (KR)
(74) Representative: Kuhnen & Wacker Patent- und Rechtsanwaltsbüro PartG mbB

(56) References cited:
- US-A1- 2021 082 815
- US-A1- 2022 028 895
- US-A1- 2022 367 454
- US-A1- 2023 386 971

## Description

### TECHNICAL FIELD

The present inventive concept relates to a semiconductor device, and more particularly, to a semiconductor device including a through-substrate via.

### DISCUSSION OF THE RELATED ART

US 2022/367454 A1 discloses backside interconnect structures having reduced critical dimensions for semiconductor devices and methods of forming the same. In an embodiment of this prior art, a device includes a first transistor structure over a front-side of a substrate; a first backside interconnect structure over a backside of the substrate, the first backside interconnect structure including first conductive features having tapered sidewalls with widths that narrow in a direction away from the substrate; a power rail extending through the substrate, the power rail being electrically coupled to the first conductive features; and a first source/drain contact extending from the power rail to a first source/drain region of the first transistor structure.

US 2023/386971 A1 discloses methods of forming through vias for providing connections between a front-side of a substrate and a backside of the substrate and semiconductor devices including the same. In an embodiment of this prior art, a semiconductor device includes a gate structure on a substrate; a first isolation feature extending partially through the gate structure; a first conductive feature extending through the first isolation feature; and a second conductive feature extending partially through the gate structure, the second conductive feature being electrically coupled to the first conductive feature.

US 2022/028895 A1 discloses an integrated circuit device that includes an embedded insulation layer, a semiconductor layer on the embedded insulation layer, the semiconductor layer having a main surface, and a plurality of fin-type active areas protruding from the main surface to extend in a first horizontal direction and in parallel with one another, a separation insulation layer separating the semiconductor layer into at least two element regions adjacent to each other in a second horizontal direction intersecting the first horizontal direction, source/drain regions on the plurality of fin-type active areas, a first conductive plug on and electrically connected to the source/drain regions, a buried rail electrically connected to the first conductive plug while penetrating through the separation insulation layer and the semiconductor layer, and a power delivery structure arranged in the embedded insulation layer, the power delivery structure being in contact with and electrically connected to the buried rail.

Typically, a semiconductor device may include an integrated circuit having, for example, metal-oxide-semiconductor field effect transistors (MOSFET). As size and design for the semiconductor device continue to become smaller, MOSFETs are increasingly being scaled down. The scale-down of the MOSFET may cause characteristics of certain semiconductor devices to degrade. Accordingly, research has been conducted to overcome the limitations resulting from increased integration of the semiconductor device and to manufacture the semiconductor device with increased performance.

### SUMMARY

The invention is set out in claim 1.

According to embodiments of the present inventive concept, a semiconductor device includes: a substrate including active patterns; a device isolation layer disposed between the active patterns; a stacked pattern disposed on the substrate; a power transmission network layer disposed on a first surface of the substrate; a first through via penetrating the stacked pattern; and a second through via disposed between the power transmission network layer and the first through via, wherein the second through via penetrates the active patterns and the device isolation layer.

### BRIEF DESCRIPTION OF THE DRAWINGS

The above and other aspects of the present inventive concept will become more apparent by describing in detail embodiments thereof, with reference to the accompanying drawings, in which:
FIGS. 1, 2 and 3 are diagrams illustrating a semiconductor device according to embodiments of the present inventive concept.
FIG. 4 is a plan view illustrating a semiconductor device according to embodiments of the present inventive concept.
FIGS. 5A, 5B, 5C, and 5D are cross-sectional views taken along lines A-A', B-B', C-C', and D-D' of FIG. 4, respectively.
FIG. 6 is a plan view for illustrating a semiconductor device according to embodiments of the present inventive concept.
FIGS. 7A, 7B, 8A, 8B, 9A, and 9B are cross-sections illustrating a semiconductor device according to embodiments of the present inventive concept, wherein FIGS. 7A, 8A, and 9A are cross-sectional views taken along line E-E' of FIG. 6, and FIGS. 7B, 8B and 9B are cross-sectional views taken along line F-F' of FIG. 6.
FIGS. 10 and 11 are plan views illustrating an arrangement of tap cells of a semiconductor device according to embodiments of the present inventive concept.
FIGS. 12A, 12B, 13A, 13B, 14A, 14B, 15A, 15B, 16A, and 16B are diagrams illustrating a method of manufacturing a semiconductor device according to embodiments of the present inventive concept, wherein FIGS. 12A, 13A, 14A, 15A, and 16A are cross-sectional views taken along line E-E' of FIG. 6, and FIGS. 12B, 13B, 14B, 15B, and 16B are cross-sectional views taken along line F-F' of FIG. 6.

### DETAILED DESCRIPTION OF THE EMBODIMENTS

Hereinafter, embodiments of the present inventive concept will be described with reference to the attached drawings. The same reference numerals may refer to the same elements throughout the specification and drawings, and thus, their descriptions that are redundant may be omitted.

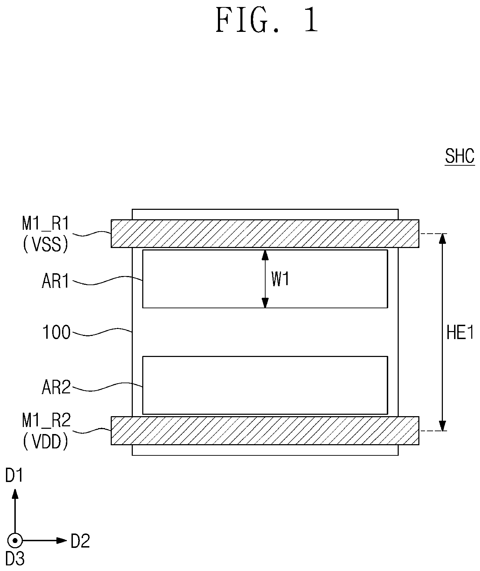

FIGS. 1 to 3 are diagrams illustrating a semiconductor device according to embodiments of the present inventive concept.

Referring to FIG. 1, a single height cell SHC may be provided. A first power line M1_R1 and a second power line M1_R2 may be provided on a substrate 100. The first power line M1_R1 may be a conduction path, to which a source voltage VSS or a ground voltage is provided. The second power line M1_R2 may be a conduction path, to which a drain voltage VDD or a power voltage is provided.

The single height cell SHC may be defined between the first and second power lines M1_R1 and M1_R2. The single height cell SHC may include a first active region AR1 and a second active region AR2. For example, one of the first active region AR1 and the second active region AR2 may be a PMOSFET region. The other one of the first active region AR1 and the second active region AR2 may be an NMOSFET region. For example, the single height cell SHC may have a CMOS structure provided between the first power line M1_R1 and the second power line M1_R2.

Each of the first active region AR1 and the second active region AR2 may have a first width W1 in a first direction D1. A length of the single height cell SHC in the first direction D1 may be defined as a first height HE1. The first height HE1 may be substantially equal to a distance (e.g., pitch) between the first power line M1_R1 and the second power line M1_R2.

The single height cell SHC may constitute one logic cell. In this specification, a logic cell may refer to a logic element (e.g., AND, OR, XOR, XNOR, inverter, etc.) that performs a specific function. That is, the logic cell may include transistors for configuring a logic element and wirings connecting the transistors to each other.

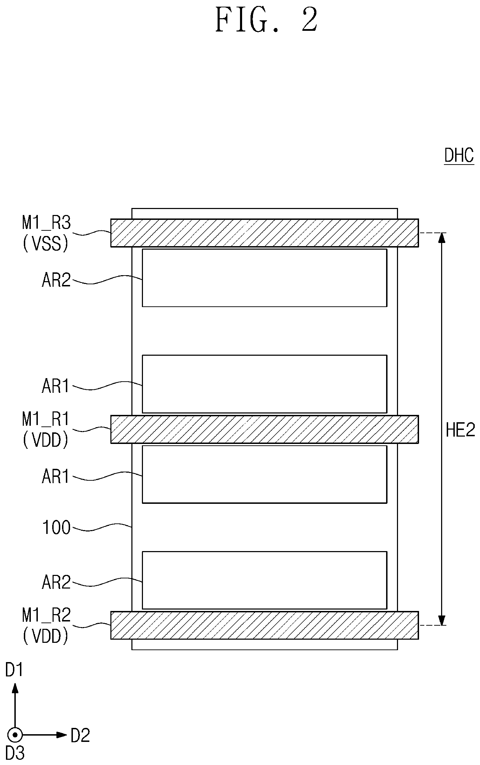

Referring to FIG. 2, a double height cell DHC may be provided. A first power line M1_R1, a second power line M1_R2, and a third power line M1_R3 may be provided on a substrate 100. The second power line M1_R2 may be disposed between the first power line M1_R1 and the third power line M1_R3. For example, the third power line M1_R3 may be a path through which the source voltage VSS is provided.

The double height cell DHC may be defined between the first power line M1_R1 and the third power line M1_R3. The double height cell DHC may include two first active regions AR1 and two second active regions AR2.

The first active regions AR1 may be adjacent to the first power line M1_R1. One of the second active regions AR2 may be adjacent to the second power line M1_R2. The other one of the second active regions AR2 may be adjacent to the third power line M1_R3. When viewed in a plan view, the first power line M1_R1 may be disposed between two first active regions AR1.

A length of the double height cell DHC in the first direction D1 may be defined as a second height HE2. The second height HE2 may be approximately twice the first height HE1 of FIG. 1. For example, the first active regions AR1 of the double height cell DHC may be bundled to operate as one PMOSFET region. Accordingly, a channel size of the PMOS transistor of the double height cell DHC may be larger than a channel size of the PMOS transistor of the single height cell SHC of FIG. 1.

For example, the channel size of the PMOS transistor of a double height cell DHC may be approximately twice that of the PMOS transistor of a single height cell SHC. Accordingly, the double height cell DHC may operate at a speed that is higher than that of a single height cell SHC.

In this specification, the double height cell DHC shown in FIG. 2 may be defined as a multi-height cell. A multi-height cell may include a triple-height cell whose cell height is approximately three times that of a single-height cell SHC.

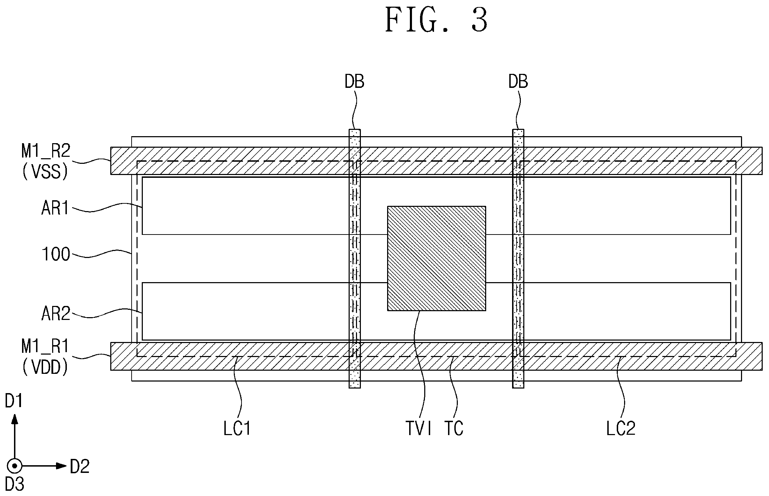

Referring to FIG. 3, a substrate 100 may include a first logic cell LC1, a second logic cell LC2, and a tap cell TC that are arranged two-dimensionally. A first power line M1_R1 and a second power line M1_R2 may be provided on the substrate 100. The first logic cell LC1, the second logic cell LC2, and the tap cell TC may be disposed between the first power line M1_R1 and the second power line M1_R2. The first logic cell LC1 and the second logic cell LC2 may be spaced apart from each other in a second direction D2. The tap cell TC may be disposed between the first logic cell LC1 and the second logic cell LC2. For example, each of the first logic cell LC1 and the second logic cell LC2 may be a single height cell SHC described with reference to FIG. 1.

Each of separation structures DB may be provided between the first logic cell LC1 and the tap cell TC and between the second logic cell LC2 and the tap cell TC, respectively. The separation structures DB may be spaced apart from each other in the second direction D2, and each of the separation structures DB may extend in the first direction D1. Each of the first active regions AR1 and the second active regions AR2 of the first logic cell LC1, the second logic cell LC2, and the tap cell TC may be electrically separated by the separation structures DB, respectively.

The tap cell TC may include a through via TVI. The through via TVI may be connected to a power transmission network layer described later. For example, the tap cell TC may be a cell for applying voltage adjacent to the first logic cell LC1 and the second logic cell LC2 from the power transmission network layer, which will be described later. In addition, the tap cell TC may be a cell for transmitting signals to the first logic cell LC1 and the second logic cell LC2. That is, the tap cell TC might not include a logic element, unlike the first logic cell LC1 and the second logic cell LC2. For example, the tap cell TC may be a type of dummy cell that may apply voltage or transmit the signals to the first logic cell LC1 and the second logic cell LC2, but might not perform a circuit function. Accordingly, the voltage or signals may be quickly provided to the first and second logic cells LC1 and LC2 adjacent to the tap cell TC. Accordingly, electrical performance of the semiconductor device may be increased.

An arrangement of the first logic cell LC1, the second logic cell LC2, and the tap cell TC shown in FIG. 3 is an example, and the arrangement between the first logic cell LC1, the second logic cell LC2, and the tap cell TC may be provided in various ways. For example, at least one of the first logic cell LC1 and/or the second logic cell LC2 may be the multi-height cell described with reference to FIG. 2. Additionally, a plurality of tap cells TC may be provided.

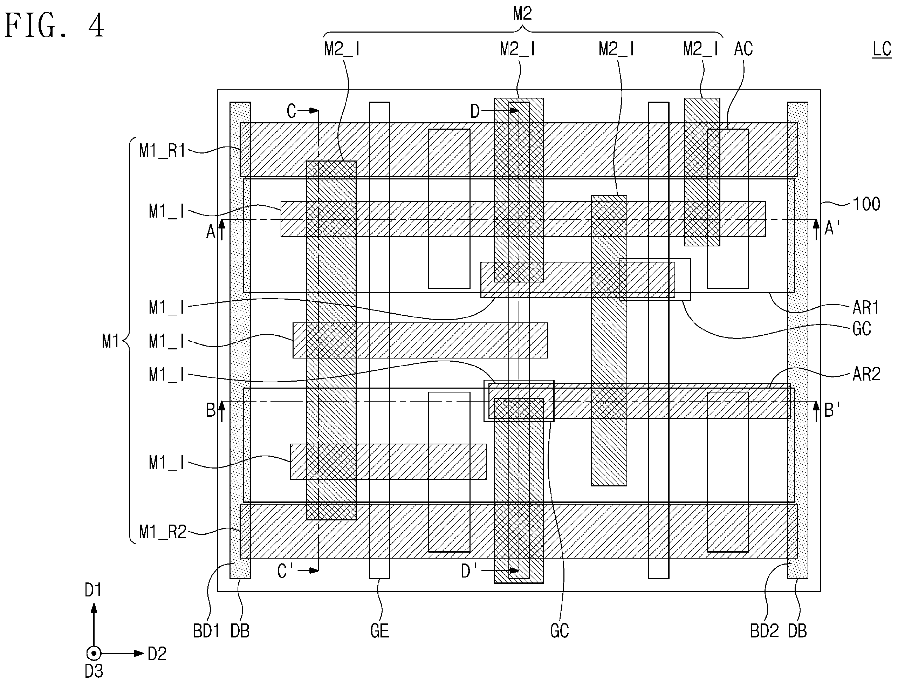

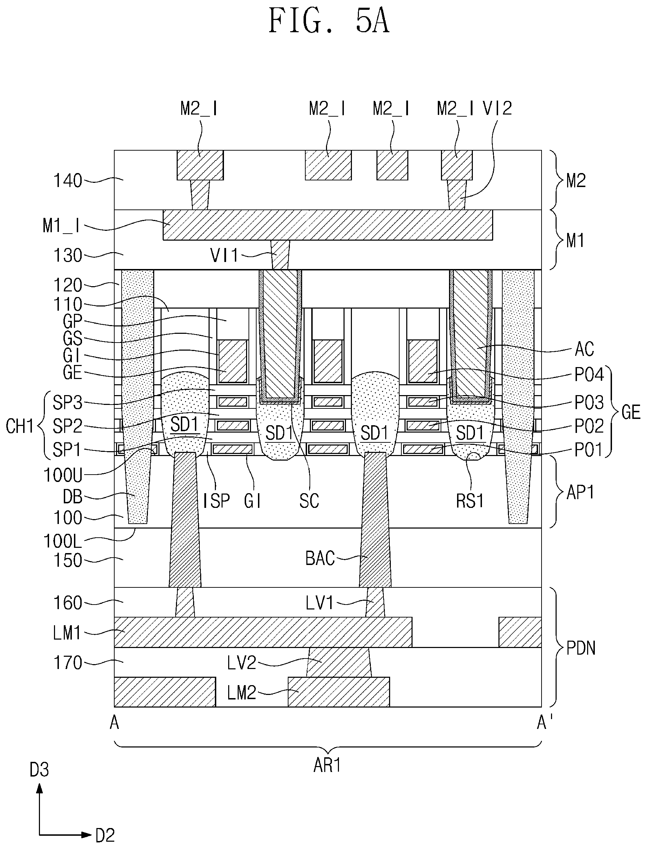

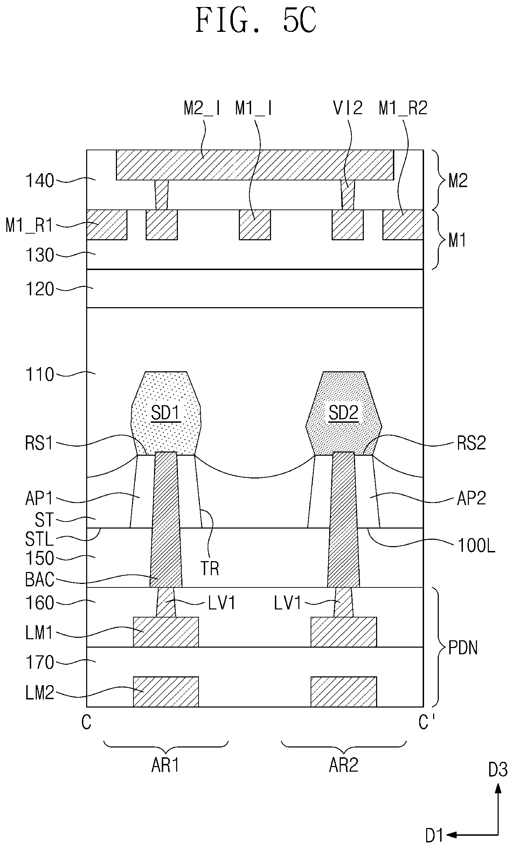

FIG. 4 is a plan view for illustrating a semiconductor device according to embodiments of the present inventive concept. FIGS. 5A to 5D are cross-sectional views taken along lines A-A', B-B', C-C', and D-D' of FIG. 4, respectively.

Referring to FIGS. 4 and 5A to 5D, a substrate 100 including a logic cell LC may be provided. The logic cell LC may be either the first logic cell LC1 or the second logic cell LC2 described with reference to FIG. 3. For example, the logic cell LC may be the single height cell SHC described with reference to FIG. 1. Logic transistors constituting a logic circuit may be disposed on the logic cell LC. The substrate 100 may be a semiconductor substrate including, for example, silicon, germanium, silicon-germanium, etc., or a compound semiconductor substrate. For example, the substrate 100 may be a silicon substrate.

The substrate 100 may include a first active region AR1 and a second active region AR2. Each of the first and second active regions AR1 and AR2 may extend in the second direction D2. For example, the first active region AR1 may be an NMOSFET region, and the second active region AR2 may be a PMOSFET region.

The substrate 100 may include a first active pattern AP1 and a second active pattern AP2. The first active pattern AP1 may be disposed on the first active region AR1, and the second active pattern AP2 may be disposed on the second active region AR2. The first active pattern AP1 and the second active pattern AP2 may be defined by a trench TR formed in the substrate 100. The first and second active patterns AP1 and AP2 may extend in the second direction D2.

According to embodiments of the present inventive concept, the remainder of the substrate 100 except for the first and second active patterns AP1 and AP2 may be removed through a planarization process. Accordingly, the first and second active patterns AP1 and AP2 of the substrate 100 may remain. That is, a thickness of the first and second active patterns AP1 and AP2 may be substantially the same as a thickness of the substrate 100. For example, an upper surface 100U of the substrate 100 may correspond to upper surfaces of the first and second active patterns AP1 and AP2. A lower surface 100L of the substrate 100 may correspond to lower surfaces of the first and second active patterns AP1 and AP2. For example, as remainder of the substrate 100 is removed leaving the first and second active patterns AP1 and AP2, the thickness of the substrate 100 may be reduced. Accordingly, the semiconductor device may be miniaturized.

A device isolation layer ST may be provided between the first and second active patterns AP1 and AP2. The device isolation layer ST may fill the trench TR. A lower surface STL of the device isolation layer ST may be substantially coplanar with the lower surfaces of the first and second active patterns AP1 and AP2. For example, the lower surface STL of the device isolation layer ST may be positioned at substantially the same level as the lower surface 100L of the substrate 100. For example, the device isolation layer ST may include a silicon oxide layer. The device isolation layer ST might not cover the first and second channel patterns CH1 and CH2, which will be described later.

A first channel pattern CH1 may be provided on the first active pattern AP1. A second channel pattern CH2 may be provided on the second active pattern AP2. Each of the first channel pattern CH1 and the second channel pattern CH2 may include a first semiconductor pattern SP1, a second semiconductor pattern SP2, and a third semiconductor pattern SP3 sequentially stacked on the first active pattern AP1 and the second active pattern AP2. The first to third semiconductor patterns SP1, SP2, and SP3 may be spaced apart from each other in a vertical direction (e.g., third direction D3).

Each of the first to third semiconductor patterns SP1, SP2, and SP3 may include, for example, silicon (Si), germanium (Ge), or silicon-germanium (SiGe). For example, each of the first to third semiconductor patterns SP1, SP2, and SP3 may include crystalline silicon, and more specifically, may include single crystalline silicon. In addition, the first to third semiconductor patterns SP1, SP2, and SP3 may be stacked nanosheets.

A plurality of first source/drain patterns SD1 may be provided on the first active pattern AP1. A plurality of first recesses RS1 may be formed on an upper part of the first active pattern AP1. Each of the first source/drain patterns SD1 may be provided in the first recesses RS1, respectively. The first source/drain patterns SD1 may be impurity regions having a first conductivity type (e.g., n-type). The first channel pattern CH1 may be disposed between the first source/drain patterns SD1 that are adjacent to each other in the second direction D2. For example, the stacked first to third semiconductor patterns SP1, SP2, and SP3 of the first channel pattern CH1 may connect first source/drain patterns SD1 that are adjacent to each other in the second direction D2.

A plurality of second source/drain patterns SD2 may be provided on the second active pattern AP2. A plurality of second recesses RS2 may be formed on an upper part of the second active pattern AP2. Each of the second source/drain patterns SD2 may be provided in the second recesses RS2, respectively. The second source/drain patterns SD2 may be impurity regions having a second conductivity type (e.g., p-type). The second channel pattern CH2 may be disposed between the second source/drain patterns SD2 that are adjacent to each other in the second direction D2. For example, the stacked first to third semiconductor patterns SP1, SP2, and SP3 of the second channel pattern CH2 may connect the second source/drain patterns SD2 that are adjacent to each other in the second direction D2.

The first and second source/drain patterns SD1 and SD2 may be epitaxial patterns formed through a selective epitaxial growth (SEG) process. For example, upper surface of each of the first and second source/drain patterns SD1 and SD2 may be higher than an upper surface of the third semiconductor pattern SP3. In addition, an upper surface of at least one of the first and/or second source/drain patterns SD1 and/or SD2 may be positioned at substantially the same level as the upper surface of the third semiconductor pattern SP3.

For example, the first source/drain patterns SD1 may include the same semiconductor element (e.g., Si) as the substrate 100. The second source/drain patterns SD2 may include a semiconductor element (e.g., SiGe) having a lattice constant that is greater than a lattice constant of the semiconductor element (e.g., Si) of the substrate 100. Accordingly, the second source/drain patterns SD2 adjacent to each other in the second direction D2 may provide compressive stress to the second channel pattern CH2 that is between the second source/drain patterns SD2.

For example, sidewalls of the second source/drain patterns SD2 may have an uneven embossed shape. For example, the sidewalls of the second source/drain patterns SD2 may have a wavy profile. The sidewalls of the second source/drain patterns SD2 may protrude toward first to third inner electrodes PO1, PO2, and PO3 of a gate electrodes GE, which will be described later.

Gate electrodes GE may be provided on the first and second channel patterns CH1 and CH2. Each of the gate electrodes GE may extend in the first direction D1 across the first and second channel patterns CH1 and CH2. Each of the gate electrodes GE may vertically overlap the first and second channel patterns CH1 and CH2. The gate electrodes GE may be spaced apart from each other in the second direction D2.

Each of the gate electrodes GE may include a first inner electrode PO1, a second inner electrode PO2, a third inner electrode PO3, and an outer electrode PO4. The first inner electrode PO1 may be disposed between the first active pattern AP1 and the first semiconductor pattern SP1 and between the second active pattern AP2 and the first semiconductor pattern SP1. The second inner electrode PO2 may be disposed between the first semiconductor pattern SP1 and the second semiconductor pattern SP2. The third inner electrode PO3 may be disposed between the second semiconductor pattern SP2 and the third semiconductor pattern SP3, and the outer electrode PO4 may be disposed on the third semiconductor pattern SP3.

Each of the gate electrodes GE may be provided on an upper surface, a bottom surface, and both sidewalls of each of the first to third semiconductor patterns SP1, SP2, and SP3. For example, a transistor according to an embodiment of the present inventive concept may be a three-dimensional field effect transistor (e.g., MBCFET or GAAFET) in which gate electrodes GE three-dimensionally surround a channel.

On the first active region AR1, an inner spacer ISP may be provided between the first to third inner electrodes PO1, PO2, and PO3 of the gate electrodes GE and the first source/drain patterns SD1. Each of the first to third inner electrodes PO1, PO2, and PO3 of the gate electrodes GE may be spaced apart from the first source/drain patterns SD1 with the inner spacer ISP therebetween. The inner spacer ISP may prevent leakage current from the gate electrodes GE.

A pair of gate spacers GS may be provided on both side walls of the outer electrode PO4 of each of the gate electrodes GE. The gate spacers GS may extend in the first direction D1 along the gate electrodes GE. For example, the gate spacers GS may include at least one of SiCN, SiCON, and/or SiN. In addition, the gate spacers GS may include a multi-layer made of at least two of SiCN, SiCON, and SiN. For example, the gate spacers GS may include a Si-including insulating material. The gate spacers GS may function as an etch stop layer when forming active contacts AC, which will be described later. The active contacts AC may be formed in a self-aligned manner by the gate spacers GS.

Gate capping patterns GP may be provided on each of the gate electrodes GE, respectively. Each of the gate capping patterns GP may extend in the first direction D1 along the gate electrodes GE. The gate capping patterns GP may include a material that has etch selectivity with respect to first and second upper insulating layers 110 and 120, which will be described later. For example, the gate capping patterns GP may include at least one of SiON, SiCN, SiCON, and SiN.

A gate insulating layer GI may be provided between the gate electrodes GE and the first channel pattern CH1 and between the gate electrodes GE and the second channel pattern CH2. The gate insulating layer GI may cover an upper surface, a bottom surface, and both sidewalls of each of the first to third semiconductor patterns SP1, SP2, and SP3. The gate insulating layer GI may cover an upper surface of the device isolation layer ST that is below the gate electrodes GE. For example, the gate insulating layer GI may include a silicon oxide layer, a silicon oxynitride layer, and/or a high-k dielectric layer. In addition, the gate insulating layer GI may have a structure in which a silicon oxide layer and a high-k dielectric layer are stacked on each other. The high dielectric layer may include a high dielectric constant material that has a higher dielectric constant than that of the silicon oxide layer. As an example, the high dielectric constant material include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, and strontium titanium. oxide, lithium oxide, aluminum oxide, lead scandium tantalum oxide, and/or lead zinc niobate.

According to an embodiment of the present inventive concept, the semiconductor device may include a negative capacitance (NC) FET using a negative capacitor. For example, the gate insulating layer GI may include a ferroelectric material layer with ferroelectric properties and a paraelectric material layer with paraelectric properties.

The ferroelectric layer may have a negative capacitance, and the paraelectric layer may have a positive capacitance. When two or more capacitors are connected in series and each capacitor has a positive capacitance, a total capacitance may be reduced to a value that is less than a capacitance of each of the capacitors. In addition, when at least one of serially-connected capacitors has a negative capacitance, a total capacitance of the serially-connected capacitors may have a positive value and may be greater than an absolute value of each capacitance.

When a ferroelectric layer having a negative capacitance and a paraelectric layer having a positive capacitance are connected in series, a total capacitance of the serially-connected ferroelectric and paraelectric layers may be increased. Due to such an increase of the total capacitance, a transistor including the ferroelectric layer may have a subthreshold swing (SS), which is less than about 60 mV/decade, at the room temperature.

The ferroelectric layer may have the ferroelectric property. The ferroelectric layer may be formed of or include at least one of, for example, hafnium oxide, hafnium zirconium oxide, barium strontium titanium oxide, barium titanium oxide, and/or lead zirconium titanium oxide. Here, the hafnium zirconium oxide may be hafnium oxide that is doped with zirconium (Zr). In addition, the hafnium zirconium oxide may be a compound including hafnium (Hf), zirconium (Zr), and/or oxygen (O).

The ferroelectric layer may further include dopants. For example, the dopants may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and/or tin (Sn). The kind of the dopants in the ferroelectric layer may be variously changed depending on a ferroelectric material included in the ferroelectric layer.

When the ferroelectric layer includes hafnium oxide, the dopants in the ferroelectric layer may include at least one of, for example, gadolinium (Gd), silicon (Si), zirconium (Zr), aluminum (Al), and/or yttrium (Y).

When the dopants are aluminum (Al), a content of aluminum in the ferroelectric layer may range from about 3 to about 8 at % (atomic percentage). Here, a content of the aluminum as the dopants may be a ratio of the number of aluminum atoms to the number of hafnium and aluminum atoms.

When the dopants are silicon (Si), a content of silicon in the ferroelectric layer may range from about 2 at % to about 10 at %. When the dopants are yttrium (Y), a content of yttrium in the ferroelectric layer may range from about 2 at % to about 10 at %. When the dopants are gadolinium (Gd), a content of gadolinium in the ferroelectric layer may range from about 1 at % to about 7 at %. When the dopants are zirconium (Zr), a content of zirconium in the ferroelectric layer may range from about 50 at % to about 80 at %.

The paraelectric layer may have the paraelectric property. The paraelectric layer may be formed of or include at least one of, for example, silicon oxide and/or high-k metal oxides. The metal oxides, which can be used as the paraelectric layer, may include at least one of, for example, hafnium oxide, zirconium oxide, and/or aluminum oxide, but the present inventive concept is not limited thereto.

The ferroelectric layer and the paraelectric layer may be formed of or include the same material as each other. The ferroelectric layer may have the ferroelectric property, but the paraelectric layer might not have the ferroelectric property. For example, when the ferroelectric and paraelectric layers each include hafnium oxide, a crystal structure of the hafnium oxide in the ferroelectric layer may be different from a crystal structure of the hafnium oxide in the paraelectric layer.

The ferroelectric layer may have a predetermined thickness with ferroelectric properties. In an embodiment of the present inventive concept, the ferroelectric layer may have a thickness ranging from about 0.5 to about 10 nm, but present inventive concept is not limited thereto. As a thickness associated with the occurrence of the ferroelectric property is variously changed depending on the kind of the ferroelectric material, the thickness of the ferroelectric layer may be changed depending on the kind of the ferroelectric material.

As an example, the gate insulating layer GI may include a single ferroelectric layer. As another example, the gate insulating layer GI may include a plurality of ferroelectric layers that are spaced apart from each other. The gate insulating layer GI may have a multi-layered structure, in which a plurality of ferroelectric layers and a plurality of paraelectric layers are alternately stacked on each other.

A first upper insulating layer 110 may be provided on the substrate 100. The first upper insulating layer 110 may cover the gate spacers GS and the first and second source/drain patterns SD1 and SD2. For example, the first upper insulating layer 110 may cover upper surfaces of the source/drain patterns SD1 and SD2 and side surfaces of the gate spacers GS. An upper surface of the first upper insulating layer 110 may be substantially coplanar with upper surfaces of the gate capping patterns GP and upper surfaces of the gate spacers GS, but the present inventive concept is not limited thereto.

A second upper insulating layer 120, a third upper insulating layer 130, and a fourth upper insulating layer 140 may be sequentially provided on the first upper insulating layer 110. For example, the first to fourth upper insulating layers 110, 120, 130, and 140 may include a silicon oxide layer.

A pair of separation structures DB facing each other in the second direction D2 may be provided on both sides (e.g., opposing sides) of the logic cell LC. Each of the separation structures DB may extend parallel to the gate electrodes GE in the first direction D1. Each of the separation structures DB may penetrate the first upper insulating layer 110 and the second upper insulating layer 120 and may extend into the first and second active patterns AP1 and AP2. The separation structures DB may penetrate a portion of each of the first and second active patterns AP1 and AP2. The separation structures DB may electrically separate the logic cell LC from other adjacent cells (e.g., logic cells and tap cells).

Active contacts AC that penetrate the first upper insulating layer 110 and the second upper insulating layer 120 and are electrically connected to some of the first and second source/drain patterns SD1 and SD2 may be provided. When viewed in a plan view, each of the active contacts AC may have a bar shape extending in the first direction D1 or a rectangular parallelepiped shape. For example, each of the active contacts AC may include a conductive pattern and a barrier pattern surrounding the conductive pattern. The barrier pattern may cover sidewalls and bottom surface of the conductive pattern.

A metal-semiconductor compound layer SC may be provided between the active contacts AC and the first source/drain patterns SD1 and between the active contacts AC and the second source/drain patterns SD2. Each of the active contacts AC may be electrically connected to the first and second source/drain patterns SD1 and SD2 through the metal-semiconductor compound layer SC. For example, the metal-semiconductor compound layer SC may include at least one of titanium-silicide, tantalum-silicide, tungsten-silicide, nickel-silicide, and/or cobalt-silicide.

Gate contacts GC may be provided through the second upper insulating layer 120 and the gate capping patterns GP and electrically connected to the gate electrodes GE. Each of the gate contacts GC may include a conductive pattern and a barrier pattern at least partially surrounding the conductive pattern. For example, the gate contacts GC may have substantially the same structure as the active contacts AC. When viewed in a plan view, each of the gate contacts GC may be disposed to overlap the first active region AR1 and the second active region AR2, respectively.

A first metal layer M1 may be provided in the third upper insulating layer 130. For example, the first metal layer M1 may include a first power line M1_R1, a second power line M1_R2, and first lines M1_I. Each of the metal lines M1_R1, M1_R2, and M1_I of the first metal layer M1 may extend parallel to each other in the second direction D2. The metal lines M1_R1, M1_R2, and M1_I of the first metal layer M1 may be spaced apart from each other in the first direction D1.

The first lines M1_I of the first metal layer M1 may be disposed between the first and second power lines M1_R1 and M1_R2. The first lines M1_I of the first metal layer M1 may be spaced apart from each other in the first direction D1. A line width of each of the first lines M1_I may be smaller than a line width of each of the first and second power lines M1_R1 and M1_R2. For example, a length of the first lines M1_I in the second direction D2 may be less a length of each of the first and second power lines M1_R1 and M1_R2 in the second direction D2.

The first metal layer M1 may further include first vias VI1. The first vias VI1 may be provided under the metal lines M1_R1, M1_R2, and M1_I of the first metal layer M1. The active contacts AC and the gate contacts GC and the metal lines M1_R1, M1_R2, and M1_I of the first metal layer M1 may be electrically connected to each other through the first vias VI1.

A second metal layer M2 may be provided in the fourth upper insulating layer 140. The second metal layer M2 may include a plurality of second lines M2_I. Each of the second lines M2_I of the second metal layer M2 may have a line shape, a bar shape, or a rectangular parallelepiped shape extending in the first direction D1. For example, each of the second lines M2_I may extend parallel to each other in the first direction D1. The second lines M2_I may be spaced apart from each other in the second direction D2.

The second metal layer M2 may include second vias VI2 provided below each of the second lines M2_I. The metal lines M1_R1, M1_R2, and M1_I of the first metal layer M1 and the second lines M2_I of the second metal layer M2 may be electrically connected to each other through the second vias VI2. For example, the second lines M2_I of the second metal layer M2 and the second vias VI2 that are below the second lines M2_I may be formed together through a dual damascene process.

A power transmission network layer PDN may be provided on the lower surface 100L of the substrate 100. The power transmission network layer PDN may include first and second lower insulating layers 160 and 170, first and second lower vias LVI1 and LVI2, and first and second lower interconnections LM1 and LM2. The first and second lower vias LV1 and LV2 may be electrically connected to the first and second lower interconnections LM1 and LM2. The first lower vias LV1 and first lower interconnections LM1 may be disposed in the first lower insulating layer 160. Second lower vias LV2 and second lower interconnections LM2 may be disposed in the second lower insulating layer 170. For example, the first lower vias LV1 may be disposed on the first lower interconnections LM1, and the second lower vias LV2 may be disposed on the second lower interconnections LM2.

An interlayer insulating layer 150 may be provided between the substrate 100 and the power transmission network layer PDN. For example, the interlayer insulating layer 150 may be in contact with the lower surface 100L of the substrate 100 and the device isolation layer ST. For example, the interlayer insulating layer 150 and the first and second lower insulating layers 160 and 170 may include a silicon oxide layer.

Back contacts BAC may be provided that penetrate the interlayer insulating layer 150 and the substrate 100 and may extend to the first and second source/drain patterns SD1 and SD2. The back contacts BAC may be connected to some of the first and second source/drain patterns SD1 and SD2. The back contacts BAC may be connected to the first lower vias LV1 of the power transmission network layer PDN. The back contacts BAC may be electrically connected to the first and second lower interconnections LM1 and LM2 through the first lower vias LV1 and the second lower vias LV2.

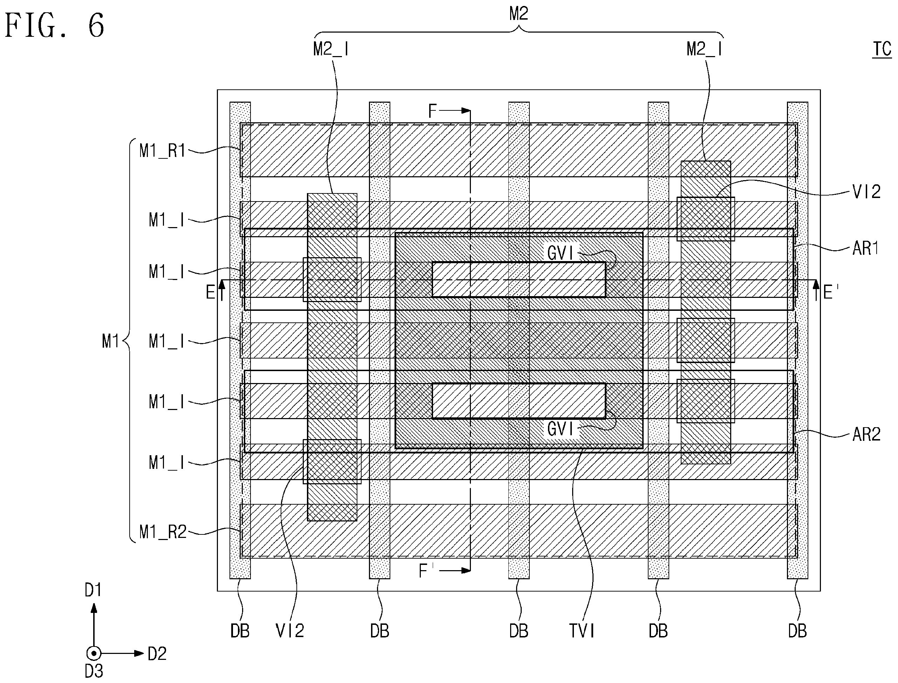

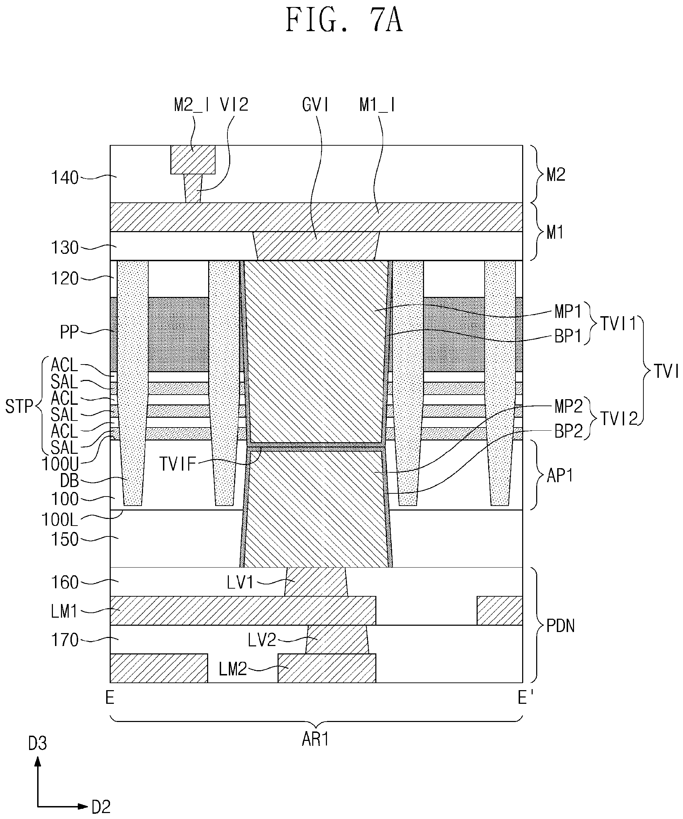

FIG. 6 is a plan view for illustrating a semiconductor device according to embodiments of the present inventive concept. FIGS. 7A to 9B are cross-sections for illustrating a semiconductor device according to embodiments of the present inventive concept. FIGS. 7A, 8A, and 9A are cross-sectional views taken along line E-E' of FIG. 6, and FIGS. 7B, 8B and 9B are cross-sectional views taken along line F-F' of FIG. 6.

Hereinafter, for convenience of explanation, description of technical features that overlap with those described with reference to FIGS. 4 and 5A to 5D will be omitted or briefly discussed, and differences will be mainly described in detail.

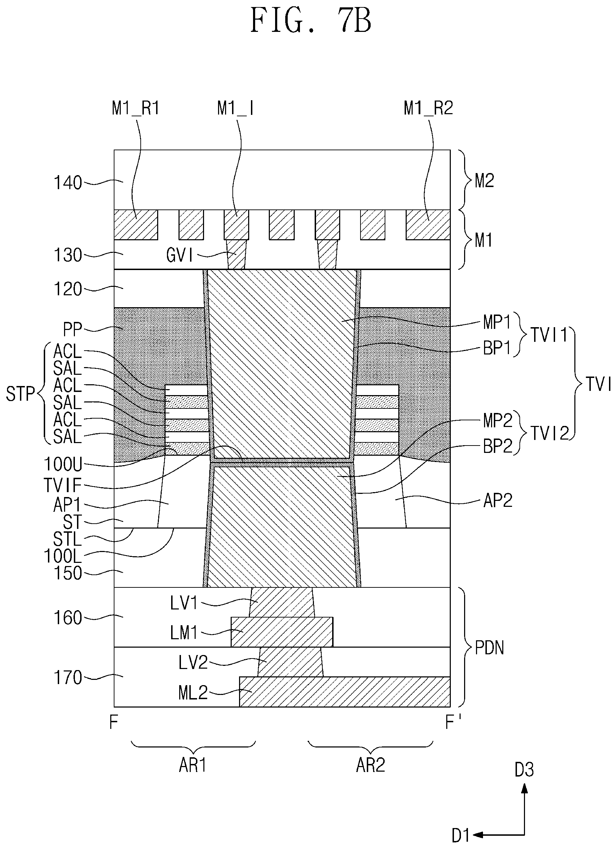

Referring to FIGS. 6, 7A, and 7B, a substrate 100 including a tap cell TC may be provided. The tap cell TC may be substantially the same as the tap cell TC described with reference to FIG. 3. Logic transistors constituting the logic circuit might not be disposed on the tap cell TC.

The substrate 100 may include a first active region AR1 and a second active region AR2. Each of the first and second active regions AR1 and AR2 may extend in the second direction D2. For example, the first active region AR1 may be an NMOSFET region, and the second active region AR2 may be a PMOSFET region. Additionally, the substrate 100 includes a first active pattern AP1 and a second active pattern AP2. The first active pattern AP1 may be disposed on the first active region AR1, and the second active pattern AP2 may be disposed on the second active region AR2.

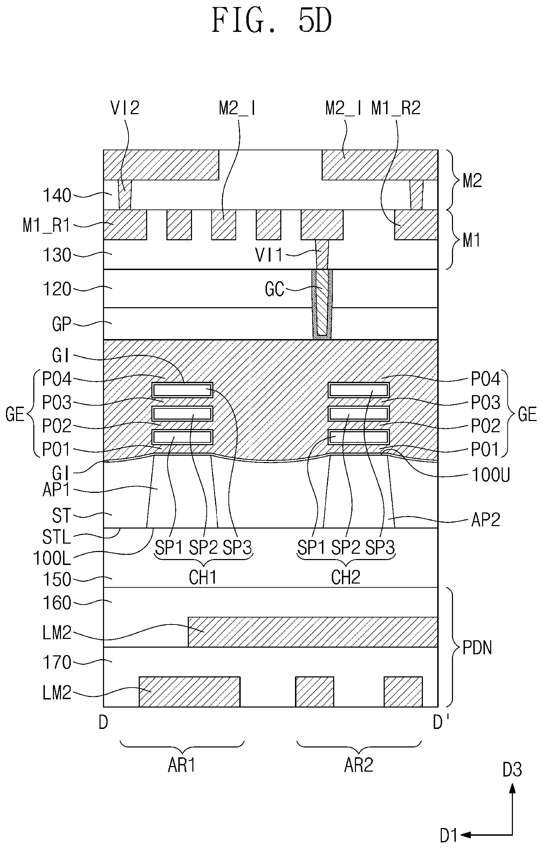

A device isolation layer ST is provided adjacent to the first and second active patterns AP1 and AP2. The device isolation layer ST may be disposed on side surfaces of the first and second active patterns AP1 and AP2. Additionally, the device isolation layer ST is disposed between the first and second active patterns AP1 and AP2 as shown in FIG. 5D. A lower surface STL of the device isolation layer ST may be substantially coplanar with lower surfaces of the first and second active patterns AP1 and AP2. For example, the lower surface STL of the device isolation layer ST may be positioned at substantially the same level as a lower surface 100L of the substrate 100. For example, the device isolation layer ST may include a silicon oxide layer.

Stacked patterns STP are provided on each of the first and second active patterns AP1 and AP2. Each of the stacked patterns STP includes active layers ACL and sacrificial layers SAL. The active layers ACL and the sacrificial layers SAL may be alternately stacked on each other. For example, the active layers ACL may be spaced apart from each other in a vertical direction, and the sacrificial layers SAL may be spaced apart from each other in the vertical direction. The active layers ACL may include substantially the same material as those of the first to third semiconductor patterns SP1, SP2, and SP3 described with reference to FIGS. 5A to 5D.

A sacrificial pattern PP may be provided on the stacked patterns STP. The sacrificial pattern PP may cover upper surfaces and side surfaces of the stacked patterns STP and the device isolation layer ST. For example, the sacrificial pattern PP may cover an upper surface of the device isolation layer ST. For example, the sacrificial pattern PP may include polysilicon. A second upper insulating layer 120 may be provided on the sacrificial pattern PP.

According to an embodiment of the present inventive concept, the gate electrodes GE described with reference to FIGS. 5A to 5D may be formed by removing the sacrificial layers SAL of the stacked patterns STP and sacrificial pattern PP. For example, as the sacrificial layers SAL and sacrificial pattern PP remain in the tab cell TC, gate electrodes GE might not be provided.

Separation structures DB may be provided in the tap cell TC. Each of the separation structures DB may extend in the first direction D1. The separation structures DB may be spaced apart from each other in the second direction D2. Each of the separation structures DB may extend into the first and second active patterns AP1 and AP2 through the second upper insulating layer 120, the sacrificial pattern PP, and the stacked patterns STP. According to one embodiment of the present inventive concept, a separation structure DB might not be disposed in a center of the tap cell TC. According to an embodiment of the present inventive concept, only one pair of separation structures DB may be provided on both sides of the tab cell TC. For example, the separation structures DB may be provided in various ways in the tap cell TC.

A through via TVI extending from the second upper insulating layer 120 to the interlayer insulating layer 150 that is disposed on the lower surface 100L of the substrate 100 is provided. When viewed in a plan view, a through via TVI may be positioned at the center of the tap cell TC. The through via TVI may be disposed between the separation structures DB. For example, the separation structures DB may be disposed on both sides (e.g., opposing sides) of the through via TVI, but the present inventive concept is not limited thereto. The through via TVI includes a first through via TVI1 and a second through via TVI2 that is disposed below the first through via TVI1. The first through via TVI1 and the second through via TVI2 are in contact with each other to form an interface TVIF.

The first through via TVI1 may extend toward the upper surface 100U of the substrate 100 through the second upper insulating layer 120, the sacrificial pattern PP, and the stacked patterns STP. The first through via TVI1 may penetrate a portion of the first and second active patterns AP1 and AP2. Additionally, the first through via TVI1 may penetrate a portion of the device isolation layer ST that is between the first and second active patterns AP1 and AP2. For example, a bottom surface of the first through via TVI1 may be disposed below the upper surfaces of the first and second active patterns AP1 and AP2. That is, the bottom surface of the first through via TVI1 may be lower than the upper surface 100U of the substrate 100. The first through via TVI1 may have a width that decreases from top to bottom thereof. For example, the first through via TVI1 may have an inverted tapered shape. For example, the first through via TVI1 may have a width that decreases as the first through via TVI1 approaches the upper surface 100U of the substrate 100.

The first through via TVI1 may include a first metal pattern MP1 and a first barrier pattern BP1 that is in contact with the first metal pattern MP1. The first barrier pattern BP1 may cover a lower surface and side surfaces of the first metal pattern MP1. That is, the first barrier pattern BP1 may extend along the side surfaces of the first metal pattern MP1 to the lower surface of the first metal pattern MP1. The first barrier pattern BP1 may prevent or reduce diffusion of elements constituting the first metal pattern MP1. For example, the first metal pattern MP1 may include at least one of aluminum (Al), copper (Cu), tungsten (W), molybdenum (Mo), and/or cobalt (Co). The first barrier pattern BP1 may be a metal layer including at least one of titanium (Ti), tantalum (Ta), tungsten (W), nickel (Ni), cobalt (Co), and/or platinum (Pt), or a metal nitride layer including at least one of titanium nitride layer (TiN), a tantalum nitride layer (TaN), a tungsten nitride layer (WN), a nickel nitride layer (NiN), a cobalt nitride layer (CoN), and/or a platinum nitride layer (PtN).

The second through via TVI2 may extend through the interlayer insulating layer 150 toward the upper surface 100U of the substrate 100. The second through via TVI2 penetrates a portion of the first and second active patterns AP1 and AP2. Additionally, the second through via TVI2 penetrates a portion of the device isolation layer ST that is disposed between the first and second active patterns AP1 and AP2. For example, an upper surface of the second through via TVI2 may be disposed below the upper surface 100U of the substrate 100 (or the upper surfaces of the first and second active patterns AP1 and AP2). Unlike the first through via TVI1, the second through via TVI2 may have a width that increases from top to bottom thereof. For example, the second through via TV12 may have a tapered shape. For example, the second through via TVI2 may have a width that decreases as the second through via TVI2 approaches the upper surface 100U of the substrate 100.

The second through via TVI2 and the first through via TVI1 are in contact with each other in the substrate 100. Accordingly, the interface TVIF between the first through via TVI1 and the second through via TVI2 may be disposed in the substrate 100. For example, the interface TVIF between the first through via TVI1 and the second through via TVI2 may be adj acent to the upper surface 100U of the substrate 100 among the upper surface 100U and the lower surface 100L of the substrate 100.

The second through via TVI2 may include a second metal pattern MP2 and a second barrier pattern BP2 that is in contact with the second metal pattern MP2. The second barrier pattern BP2 may cover an upper surface and side surfaces of the second metal pattern MP2. For example, the second barrier pattern BP2 may extend along the side surfaces of the second metal pattern MP2 to the upper surface of the second metal pattern MP2. Accordingly, the second barrier pattern BP2 may be in contact with the first barrier pattern BP1. For example, the first metal pattern MP1 and the second metal pattern MP2 may be spaced apart from each other due to the first barrier pattern BP1 and the second barrier pattern BP2 being disposed between the first metal pattern MP1 and the second metal pattern MP2. Each of the second metal pattern MP2 and the second barrier pattern BP2 may include substantially the same material as the first metal pattern MP1 and the first barrier pattern BP1, but the present inventive concept is not limited thereto. For example, the first metal pattern MP1 and the second metal pattern MP2 may include different metal materials from each other.

A first metal layer M1 may be provided in the third upper insulating layer 130. A second metal layer M2 may be provided in the fourth upper insulating layer 140. The first metal layer M1 may include giant vias GVI between the first lines M1_I and the through via TVI. The giant vias GVI may connect the first lines M1_I and the first through via TVI1 to each other. In this case, signals may be transmitted to logic cells that are adjacent to the tap cell TC through the through via TVI.

According to one embodiment of the present inventive concept, the giant vias GVI may be connected to at least one of the first and second power lines M1_R1 and/or M1_R2 of the first metal layer M1. The giant vias GVI may connect at least one of the first and/or second power lines M1_R1 and M1_R2 to the first through via TVI1. In this case, voltage may be applied to logic cells that are adjacent to the tap cell TC through the through via TVI.

For example, the through via TVI may be electrically connected to the first and second metal layers M1 and M2 through the giant vias GVI. Accordingly, a signal may be transmitted or a voltage may be applied to logic cells that are adjacent to the tap cell TC through the through via TVI.

A power transmission network layer PDN is provided on the lower surface 100L of the substrate 100. A first lower via LV1 of the power transmission network layer PDN may be disposed between the through via TVI and one of the first lower lines LM1. The first lower via LV1 may connect one of the first lower lines LM1 to the second through via TVI2. In other words, the through via TVI may be electrically connected to the power transmission network layer PDN through the first lower via LV1. For example, the through via TVI may electrically connect the power transmission network layer PDN and the first and second metal layers M1 and M2 to each other.

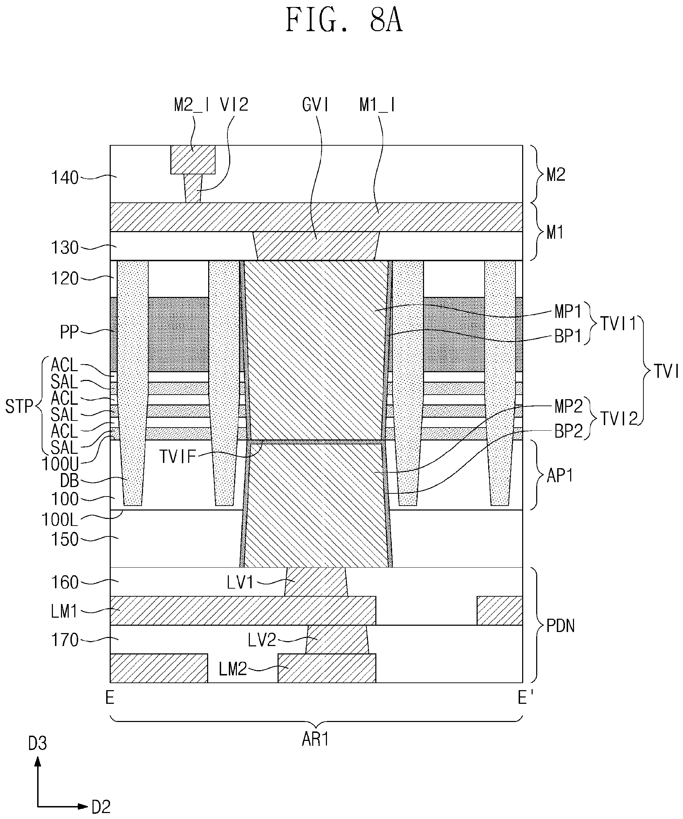

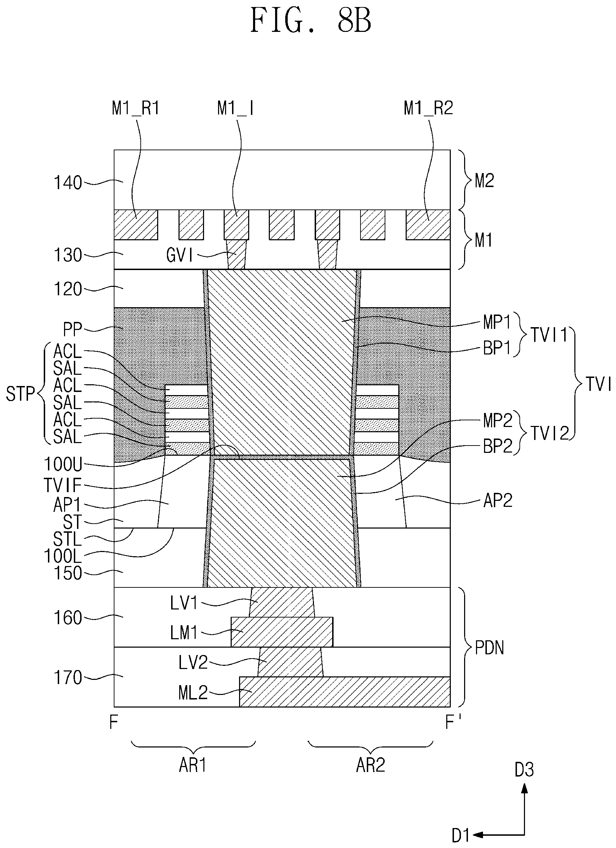

Referring to FIGS. 6, 8A, and 8B, the first through via TVI1 of the through via TVI may include a first metal pattern MP1 and a first barrier pattern BP1. The second through via TVI2 of the through via TVI may include a second metal pattern MP2 and a second barrier pattern BP2.

The first through via TVI1 may extend toward the upper surface 100U of the substrate 100 through the second upper insulating layer 120, the sacrificial pattern PP, and the stacked patterns STP. The first through via TVI1 might not penetrate the first and second active patterns AP1 and AP2 and the device isolation layer ST that is disposed between the first and second active patterns AP1 and AP2. For example, a bottom surface of the first through via TVI1 may be positioned at substantially the same level as the upper surfaces of the first and second active patterns AP1 and AP2. For example, the bottom surface of the first through via TVI1 may be substantially coplanar with the upper surface 100U of the substrate 100.

The first barrier pattern BP1 of the first through via TVI1 might not extend onto a lower surface of the first metal pattern MP1. For example, the lower surface of the first metal pattern MP1 might not be covered by the first barrier pattern BP1. For example, the first barrier pattern BP1 may be provided only on side surfaces of the first metal pattern MP1. The first barrier pattern BP1 might not be disposed between the first metal pattern MP1 and the second metal pattern MP2.

The second through via TVI2 may extend through the interlayer insulating layer 150 toward the upper surface 100U of the substrate 100. The second through via TVI2 penetrates the first and second active patterns AP1 and AP2. Additionally, the second through via TVI2 penetrates the device isolation layer ST that is disposed between the first and second active patterns AP1 and AP2. For example, the upper surface of the second through via TVI2 may be disposed on substantially the same plane as the upper surface 100U of the substrate 100 (or the upper surfaces of the first and second active patterns AP1 and AP2).

Unlike the first barrier pattern BP1, the second barrier pattern BP2 of the second through via TVI2 may extend onto an upper surface of the second metal pattern MP2. For example, the second barrier pattern BP2 may be provided on side surfaces and upper surface of the second metal pattern MP2. The second barrier pattern BP2 may be disposed between the first metal pattern MP1 and the second metal pattern MP2. The second barrier pattern BP2 may be in contact with a portion of the first metal pattern MP1. The first metal pattern MP1 and the second metal pattern MP2 may be spaced apart from each other by the second barrier pattern BP2.

The first through via TVI1 and the second through via TVI2 may be in contact with each other at substantially the same level as the upper surface 100U of the substrate 100. Accordingly, the interface TVIF between the first through via TVI1 and the second through via TVI2 may be substantially coplanar with the upper surface 100U of the substrate 100.

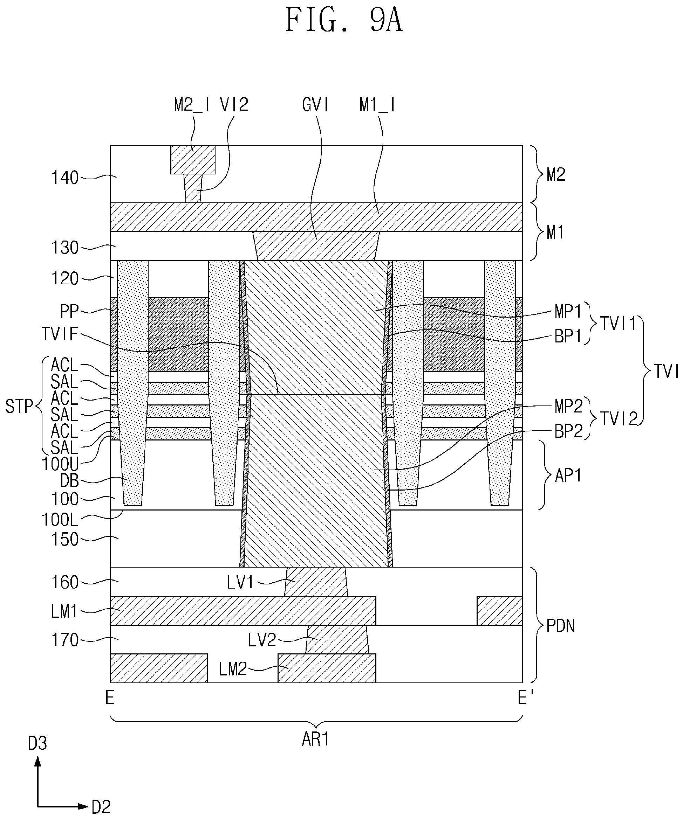

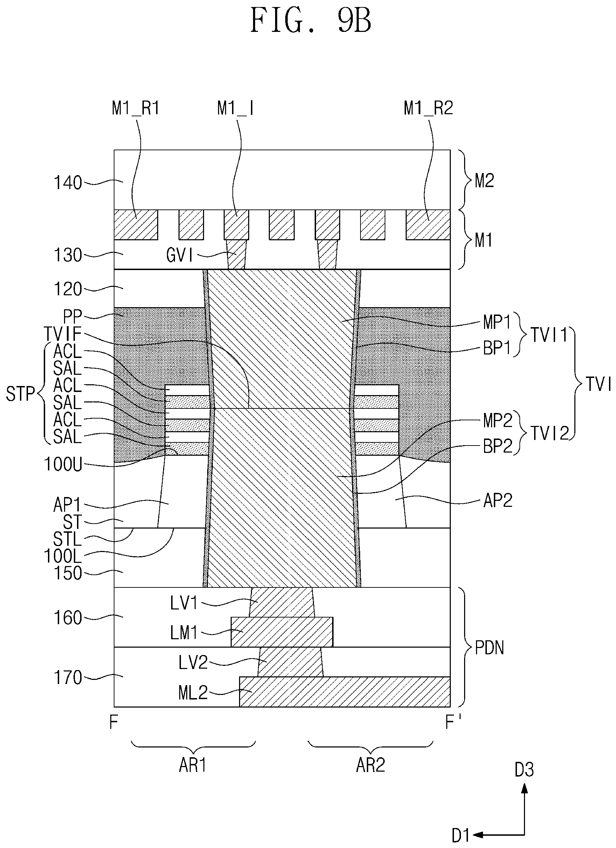

Referring to FIGS. 6, 9A, and 9B, the first through via TVI1 may include a first metal pattern MP1 and a first barrier pattern BP1 on side surfaces of the first metal pattern MP1. The second through via TVI2 may include a second metal pattern MP2 and a second barrier pattern BP2 on side surfaces of the second metal pattern MP2.

The first through via TVI1 may extend toward the upper surface 100U of the substrate 100 through a portion of the second upper insulating layer 120, the sacrificial pattern PP, and the stacked patterns STP. For example, a bottom surface of the first through via TVI1 may be disposed in the stacked patterns STP. For example, the bottom surface of the first through via TVI1 may be higher than the upper surface 100U of the substrate 100.

The second through via TVI2 may extend through the interlayer insulating layer 150 toward the upper surface 100U of the substrate 100. The second through via TVI2 may penetrate the first and second active patterns AP1 and AP2 and the device isolation layer ST that is disposed between the first and second active patterns AP1 and AP2. Additionally, the second through via TVI2 may penetrate the remainder of the stacked patterns STP. For example, an upper surface of the second through via TVI2 may be higher than the upper surface 100U of the substrate 100 (or the upper surfaces of the first and second active patterns AP1 and AP2).

The first barrier pattern BP1 of the first through via TVI1 might not extend onto the lower surface of the first metal pattern MP1. Additionally, the second barrier pattern BP2 of the second through via TVI2 might not extend onto the upper surface of the second metal pattern MP2. For example, the first barrier pattern BP1 may be provided only on the side surfaces of the first metal pattern MP1, and the second barrier pattern BP2 may be provided only on the side surfaces of the second metal pattern MP2. For example, the first barrier pattern BP1 and/or the second barrier pattern BP2 might not be disposed between the first metal pattern MP1 and the second metal pattern MP2. Accordingly, the first metal pattern MP1 and the second metal pattern MP2 may be in contact with each other.

The first through via TVI1 and the second through via TVI2 may be in contact with each other at a level that is higher than the upper surface 100U of the substrate 100. Accordingly, the interface TVIF between the first through via TVI1 and the second through via TVI2 may be higher than the upper surface 100U of the substrate 100. For example, the interface TVIF between the first through via TVI1 and the second through via TVI2 may be disposed in the stacked patterns STP.

Referring again to FIGS. 6 and 7A to 9B, the first through via TVI1 and the giant vias GVI may be formed on the upper surface 100U of the substrate 100, and the second through via TVI2 and the first lower via LV1 may be formed on the lower surface 100L of the substrate 100. For example, after the first through via TVI1 is formed, the second through via TVI2 may be formed to be in contact with the first through via TVI1. That is, the first through via TVI1 and the second through via TVI2 of the through via TVI may be formed separately through different processes. Accordingly, it is possible to prevent the through via TVI from being misaligned with the giant vias GVI and/or the first lower via LV1.

Additionally, a difference between a height of the first through via TVI1 in the third direction D3 and a height of the second through via TVI2 in the third direction D3 may be relatively small. For example, the height of the first through via TVI1 may be about 0.5 to about 2.0 of the height of the second through via TVI2. The interface TVIF between the first through via TVI1 and the second through via TVI2 may be disposed closer to the upper surface 100U than to the lower surface 100L of the substrate 100. As the first and second through vias TVI1 and TVI2 are formed at similar heights, a metal material may be easily formed without voids in the through via TVI having a large aspect ratio. Accordingly, electrical characteristics and reliability of the semiconductor device may be improved.

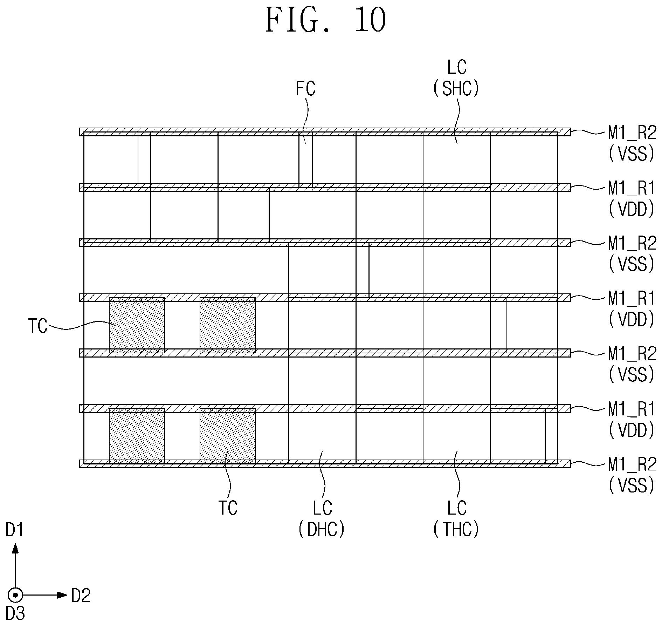

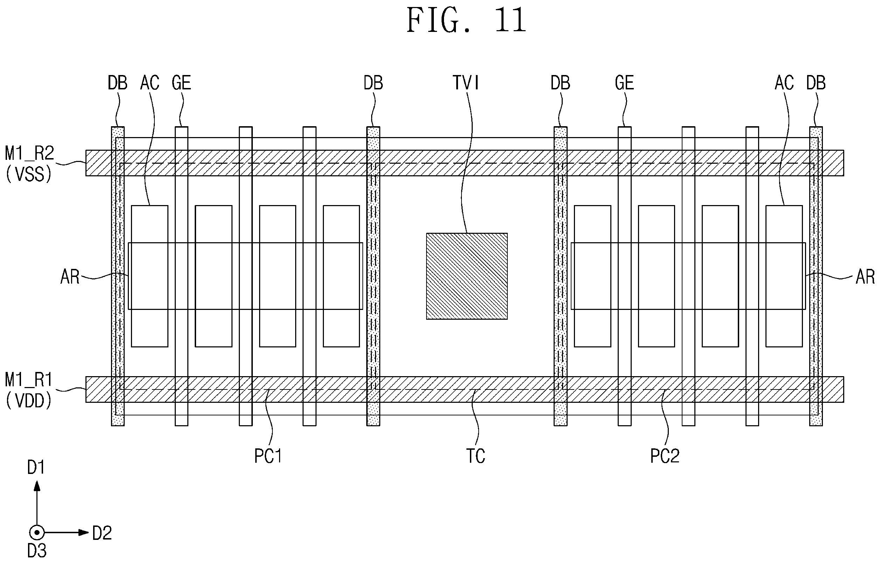

FIGS. 10 and 11 are plan views illustrating an arrangement of tap cells of a semiconductor device according to embodiments of the present inventive concept.

Referring to FIG. 10, a semiconductor device according to embodiments of the present inventive concept may be manufactured based on a designed layout. For example, the layout of a semiconductor device may be created using a layout design tool.

First and second power lines M1_R1 and M1_R2 may be disposed on the layout. For example, the first power line M1_R1 may define a path for a drain voltage VDD, and the second power line M1_R2 may define a path for a source voltage VSS. The first and second power lines M1_R1 and M1_R2 may be alternately arranged in the first direction D1 at a substantially constant pitch. Each of the first and second power lines M1_R1 and M1_R2 may extend in the second direction D2.

Logic cells LC, tap cells TC, and filler cells FC may be provided between the first and second power lines M1_R1 and M1_R2. The logic cells LC may include at least one single height cell SHC, at least one double height cell DHC, and at least one triple height cell THC. A single height cell SHC may be substantially the same as that described with reference to FIG. 1. The double height cell DHC and triple height cell THC may be substantially the same as those described with reference to FIG. 2.

The tap cells TC may be arranged to be spaced apart from the logic cells LC. Each of the tap cells TC may be substantially the same as those described with reference to FIGS. 6 and 7A to 9B. At least one of the tap cells TC might not be disposed between the logic cells LC. Additionally, at least one of the logic cells LC may not be disposed between the tap cells TC. For example, the tap cells TC may be disposed in the remaining region where the logic cells LC are not disposed.

Each of the filler cells FC may be disposed between adjacent logic cells LC. The filler cells FC may fill empty spaces that are between logic cells LC. For example, the filler cells FC may be dummy cells.

Referring to FIG. 11, first and second power lines M1_R1 and M1_R2 may be arranged on the layout. The first and second power lines M1_R1 and M1_R2 may be arranged in the first direction D1 at a substantially constant pitch. Each of the first and second power lines M1_R1 and M1_R2 may extend in the second direction D2.

Passive cells and the tap cell TC may be provided between the first and second power lines M1_R1 and M1_R2. The passive cells may include a first passive cell PC1 and a second passive cell PC2. The first and second passive cells PC1 and PC2 may be spaced apart from each other in the second direction D2. Separation structures DB may be provided on two sides of each of the first and second passive cells PC1 and PC2. Each of the first and second passive cells PC1 and PC2 may include gate electrodes GE, an active region AR, and active contacts AC. Each of the first and second passive cells PC1 and PC2 may include three-dimensional field effect transistors having a longer channel length than that described with reference to FIGS. 5A to 5D.

The tap cell TC may be disposed between the first and second passive cells PC1 and PC2. The tap cell TC may be substantially the same as that described with reference to FIGS. 6 and 7A to 9B. For example, the tap cell TC may transmit a signal or apply a voltage to the adjacent first and second passive cells PC1 and PC2.

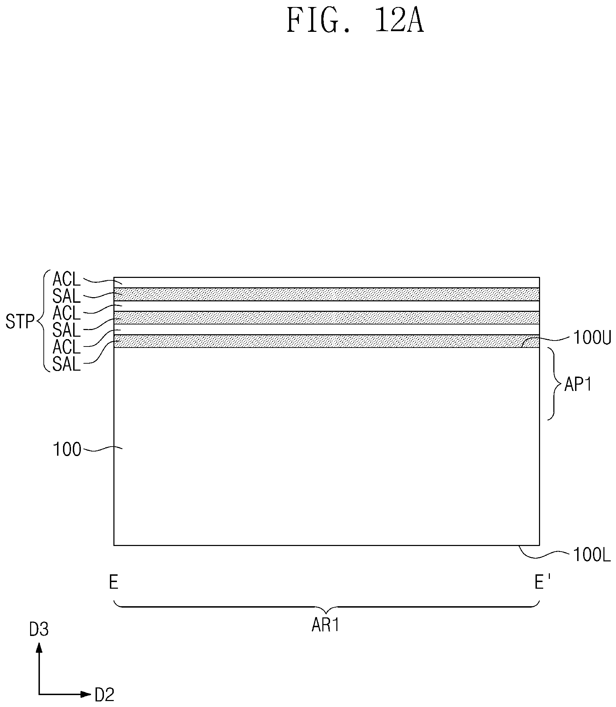

FIGS. 12A to 16B are diagrams for illustrating a method of manufacturing a semiconductor device according to embodiments of the present inventive concept. FIGS. 12A, 13A, 14A, 15A, and 16A are cross-sectional views taken along line E-E' of FIG. 6, and FIGS. 12B, 13B, 14B, 15B, and 16B are cross-sectional views taken along line F-F' of FIG. 6.

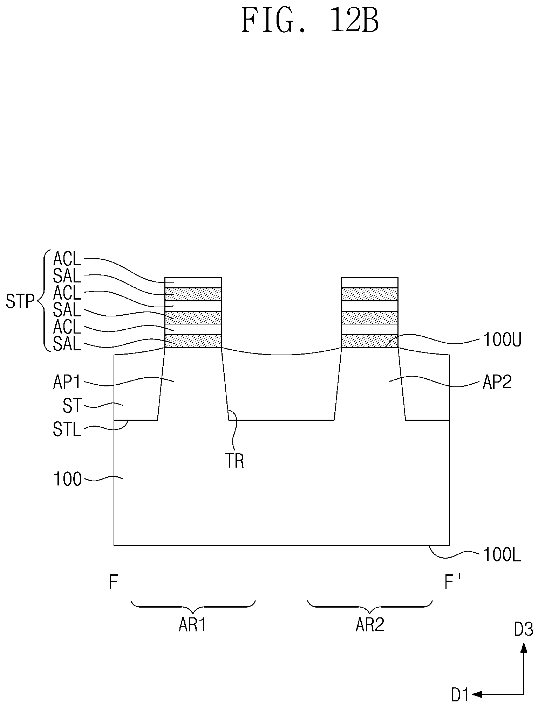

Referring to FIGS. 12A and 12B, a substrate 100 including first and second active regions AR1 and AR2 is provided. Active layers ACL and sacrificial layers SAL are alternately stacked on an upper surface 100U of a substrate 100. The active layers ACL may include one of, for example, silicon (Si), germanium (Ge), or silicon-germanium (SiGe), and the sacrificial layers SAL may include another one of silicon (Si), germanium (Ge), or silicon-germanium (SiGe).

The sacrificial layers SAL may include a material having an etch selectivity with respect to the active layers ACL. For example, the active layers ACL may include silicon (Si), and the sacrificial layers SAL may include silicon-germanium (SiGe). A concentration of germanium (Ge) in each of the sacrificial layers SAL may be about 10 at% to about 30 at%.

Each of mask patterns may be formed on the first and second active regions AR1 and AR2 of the substrate 100, respectively. Each of the mask patterns may have a line shape, a bar shape, or rectangular parallelepiped shape extending in the second direction D2. An etching process using mask patterns may be performed to form a trench TR defining a first active pattern AP1 and a second active pattern AP2. The first active pattern AP1 may be formed on the first active region AR1. The second active pattern AP2 may be formed on the second active region AR2. When viewed in a plan view, the first and second active patterns AP1 and AP2 may have a shape of lines extending parallel to each other in the second direction D2.

Stacked patterns STP are formed on each of the first and second active patterns AP1 and AP2. Each of the stacked patterns STP include the active layers ACL and the sacrificial layers SAL that are alternately stacked on the active patterns AP1 and AP2. For example, the stacked patterns STP may be formed through an etching process to form the first and second active patterns AP1 and AP2.

Afterwards, a device isolation layer ST is formed to fill the trench TR. For example, an insulating layer covering the first and second active patterns AP1 and AP2 and the stacked patterns STP may be formed on the upper surface 100U of the substrate 100, and the insulating layer may be recessed to form the device isolation layer. The stacked patterns STP may be exposed on the device isolation layer ST. In other words, the stacked patterns STP may protrude vertically above the device isolation layer ST and might not covered by the stacked patterns STP. The device isolation layer ST may include an insulating material such as a silicon oxide layer.

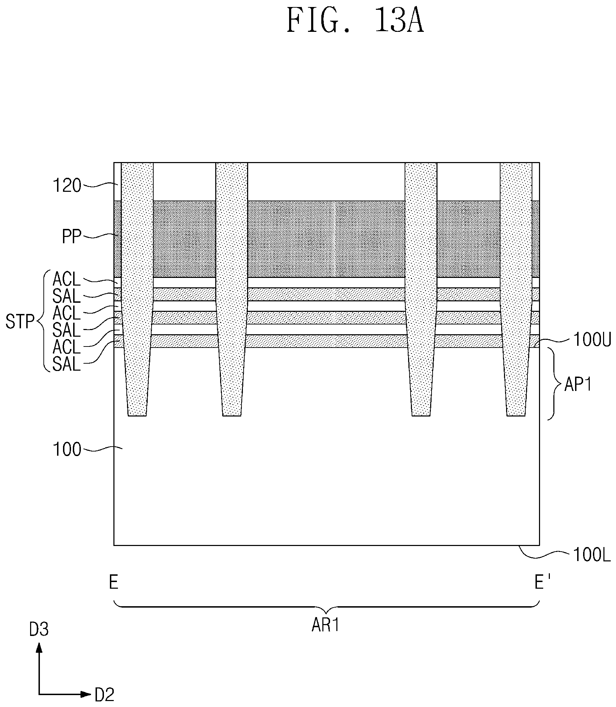

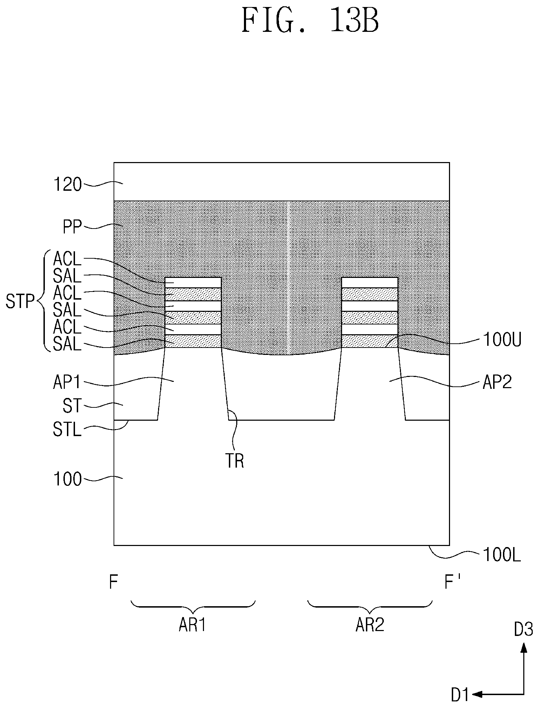

Referring to FIGS. 13A and 13B, a sacrificial pattern PP may be formed on the substrate 100 to cover the stacked patterns STP. The sacrificial pattern PP may cover an upper surface and side surfaces of the stacked patterns STP. For example, the sacrificial pattern PP may be in contact with the device isolation layer ST. A second upper insulating layer 120 may be formed on the sacrificial pattern PP. For example, the second upper insulating layer 120 may include a silicon oxide layer.

Thereafter, separation structures DB may be formed to penetrate the second upper insulating layer 120, the sacrificial pattern PP, and the stacked patterns STP. The separation structures DB may extend from the second upper insulating layer 120 to the first active pattern AP1 by penetrating the stacked patterns STP. The separation structures DB may include an insulating material such as a silicon oxide layer or a silicon nitride layer.

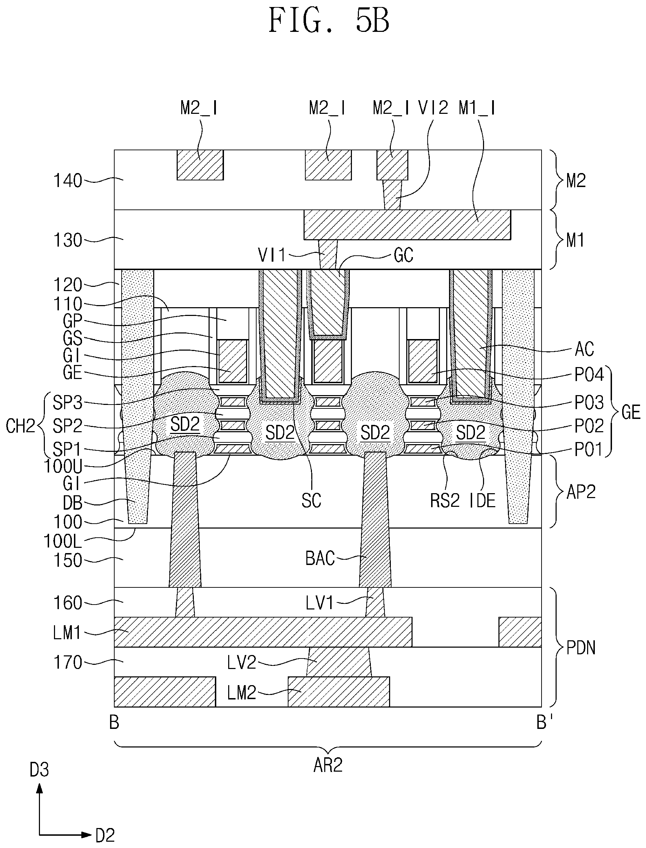

In the case of the logic cell LC described with reference to FIGS. 4 and 5A to 5D, the sacrificial pattern PP may be formed in a form of a line, bar, or a rectangular parallelepiped shape extending in the first direction D1. First and second recesses RS1 and RS2 of FIGS. 5A and 5B may be formed by using the sacrificial pattern PP, and first and second source/drain patterns SD1 and SD2 may be respectively formed in the first and second recesses RS1 and RS2. Afterwards, the sacrificial pattern PP and sacrificial layers SAL may be selectively removed, and a gate insulating layer GI and gate electrodes GE may be formed in a space where the sacrificial pattern PP and sacrificial layers SAL have been removed.

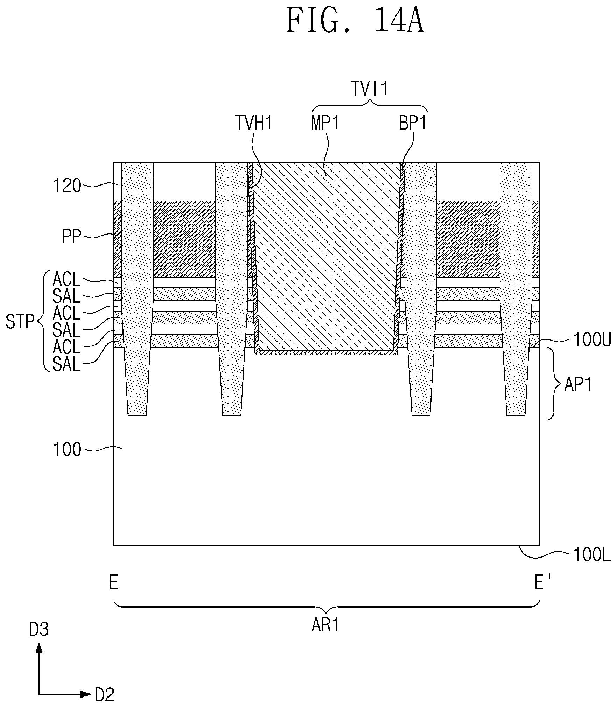

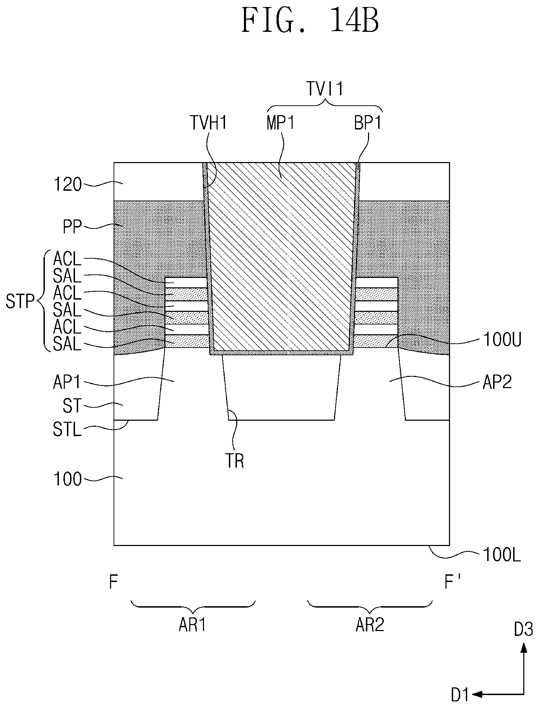

Referring to FIGS. 14A and 14B, a first through hole TVH1 penetrating the second upper insulating layer 120, a portion of the sacrificial pattern PP, and portions of the stacked patterns STP is formed to expose the first and second active patterns AP1 and AP2. The first through hole TVH1 might not be formed in the logic cell LC described with reference to FIGS. 4 and 5A to 5D. The first through hole TVI1 may be disposed between the first and second active patterns AP1 and AP2 and between the separation structures DB. The first through hole TVH1 may expose the device isolation layer ST that is disposed between the first and second active patterns AP1 and AP2. A width of the first through hole TVH1 may decrease as the first through hole TVH1 approaches the upper surface 100U of the substrate 100.

A first barrier pattern BP1 may be formed on inner walls of the first through hole TVH1. A first metal pattern MP1 may be formed on the first barrier pattern BP1 in the first through hole TVH1. Forming the first barrier pattern BP1 and the first metal pattern MP1 may include forming a first barrier layer that covers the inner walls of the first through hole TVH1 with a substantially uniform thickness, forming a first metal layer on the first barrier layer in the first through hole TVH1, and planarizing the first metal layer to expose the second upper insulating layer 120. Accordingly, the first barrier pattern BP1 may be formed from the first barrier layer, and the first metal pattern MP1 may be formed from the first metal layer. As a result, the first through via TVI1 including the first metal pattern MP1 and the first barrier pattern BP1 may be formed in the first through hole TVH1.

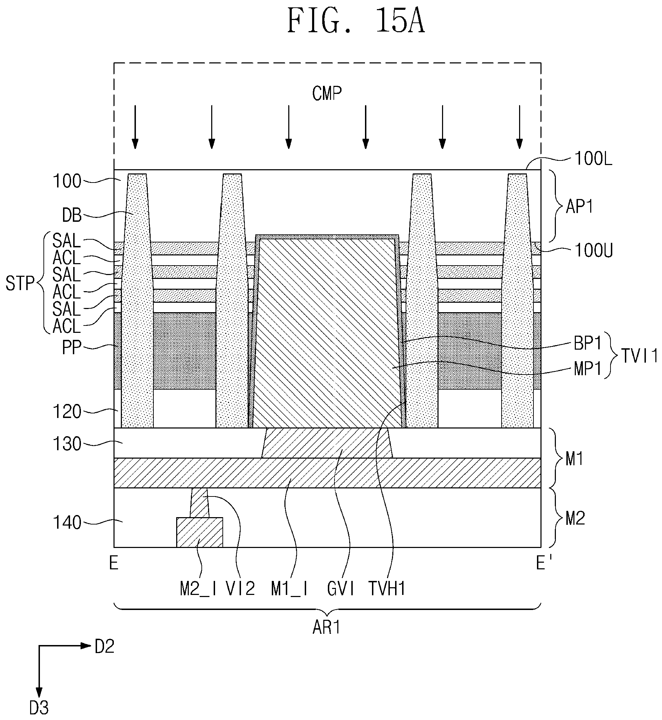

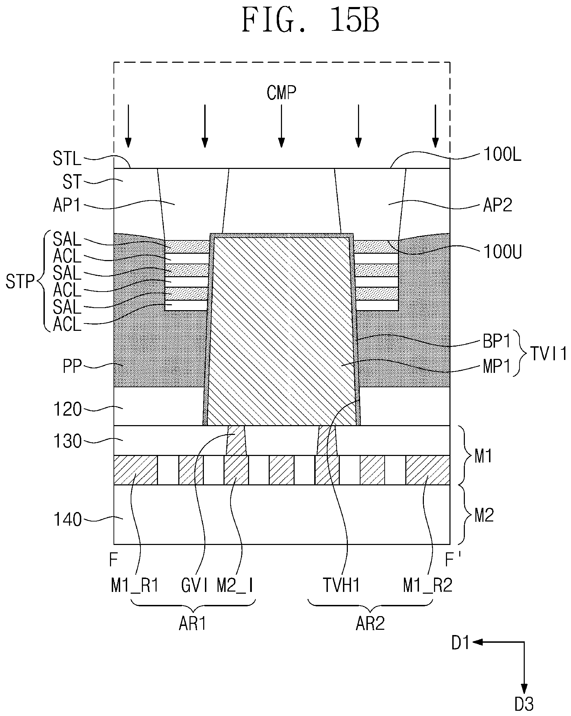

Referring to FIGS. 15A and 15B, first and second metal layers M1 and M2 may be sequentially formed on the second upper insulating layer 120. The first metal layer M1 may include first and second power lines M1_R1 and M1_R2, first lines M1_I, and giant vias GVI in the third upper insulating layer 130. The second metal layer M2 may include second lines M2_I and second vias VI2 in the fourth upper insulating layer 140.

After the second metal layer M2 is formed, a carrier substrate may be bonded to the fourth upper insulating layer 140. The semiconductor device may be turned over by using a carrier substrate. Accordingly, the lower surface 100L of the substrate 100 may be positioned at a higher level than the upper surface 100U of the substrate 100. Additionally, the lower surface 100L of the substrate 100 may be exposed to the outside.

Afterwards, a planarization process CMP may be performed on the substrate 100. Through the planarization process CMP, a thickness of the substrate 100 may be reduced. The planarization process CMP may be performed until the lower surface STL of the device isolation layer ST is exposed. For example, the planarization process CMP may remove the remainder of the substrate 100 except for the first and second active patterns AP1 and AP2. The lower surface STL of the device isolation layer ST, the lower surfaces of the first and second active patterns AP1 and AP2, and the lower surface 100L of the substrate 100 may be substantially coplanar. Accordingly, the thickness of the substrate 100 may be substantially the same as a thickness of each of the first and second active patterns AP1 and AP2. Accordingly, the semiconductor device may be miniaturized.

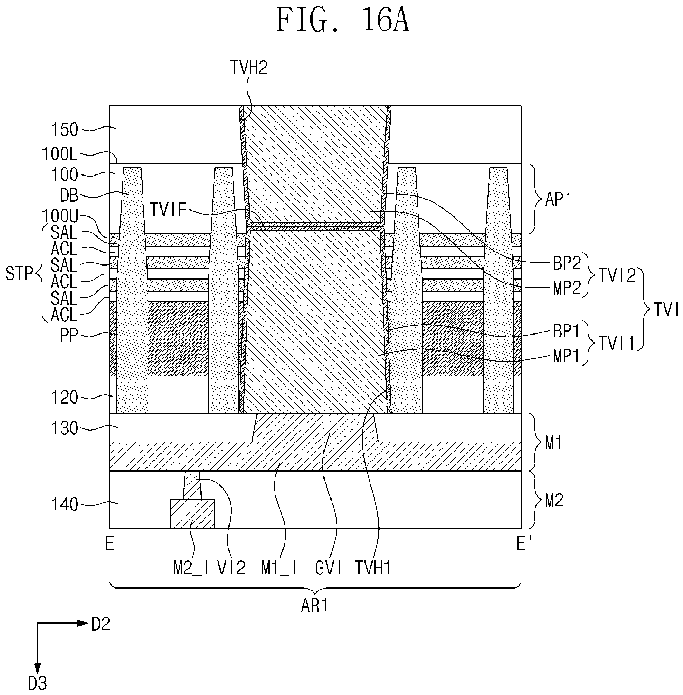

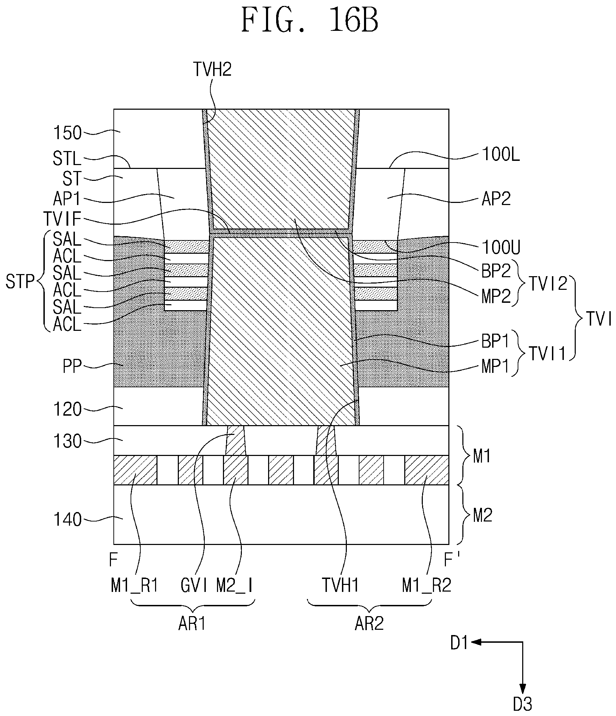

Referring to FIGS. 16A and 16B, an interlayer insulating layer 150 may be formed on the lower surface 100L of the substrate 100. A mask pattern may be formed on the interlayer insulating layer 150, and a second through hole TVH2 penetrating the interlayer insulating layer 150 and the device isolation layer ST is formed through an etching process by using the mask pattern. The second through hole TVH2 might not be formed in the logic cell LC described with reference to FIGS. 4 and 5A to 5D. The second through hole TVI2 may be disposed between the first and second active patterns AP1 and AP2 and between the separation structures DB that are adjacent to each other. The second through hole TVH2 may expose the first barrier pattern BP1 of the first through via TVI1. A width of the second through hole TVH2 may decrease as the second through hole TVH2 approaches the upper surface 100U of the substrate 100.

A second barrier pattern BP2 may be formed on inner walls of the second through hole TVH2. A second metal pattern MP2 may be formed on the second barrier pattern BP2 in the second through hole TVH2. Forming the second barrier pattern BP2 and the second metal pattern MP2 may be substantially the same as forming the first barrier pattern BP1 and the first metal pattern MP1. As a result, the second through via TVI2 may be formed in contact with the first through via TVI1. For example, a height of the second through via TVI2 may be about 0.5 to about 2.0 of the height of the first through via TVI1.

Referring again to FIGS. 7A and 7B, a power transmission network layer PDN is formed on the interlayer insulating layer 150. Forming the power transmission network layer PDN may include forming a first lower insulating layer 160, and forming a first lower via LV1 and first lower interconnections LM1 in the first lower insulating layer 160. The formation of the power transmission network layer PDN may further include forming a second lower insulating layer 170 on the first lower insulating layer 160, and forming second lower vias LV2 and second lower interconnections LM2 in the second lower insulating layer 170.

After the power transmission network layer PDN is formed, the semiconductor device may be turned over again, and the carrier substrate that is on the fourth upper insulating layer 140 may be removed.

According to embodiments of the inventive concept, the remainder of the substrate 100 except for the first and second active patterns AP1 and AP2 may be removed through the planarization process. Accordingly, the thickness of the first and second active patterns AP1 and AP2 may be substantially the same as the thickness of the substrate 100. Accordingly, the thickness of the substrate 100 may become thinner.

Additionally, the first through via TVI1 and the giant vias GVI may be formed on the upper surface 100U of the substrate 100, and the second through via TVI2 and the first lower via LV1 may be formed on the lower surface 100L of the substrate 100. The first through via TVI1 and the second through via TVI2 of the through via TVI may be individually formed through different processes from each other, and may be formed to have similar heights as each other. As a result, while preventing the through via TVI from being misaligned with the giant vias GVI and/or the first lower via LV1, the metal material may be easily formed in the through via TVI having a high aspect ratio without a void. Accordingly, electrical characteristics and reliability of the semiconductor device may be improved.

The remaining portions of the substrate of the semiconductor device according to embodiments of the present inventive concept, except the active patterns, may be removed through the planarization process. Accordingly, the thickness of the substrate may be reduced. Additionally, the first through via and the second through via may be formed individually through the different processes from each other and may be formed to have similar heights as each other. Accordingly, the misalignment of the through via with adjacent vias may be prevented, and the metal material may be easily formed without voids in the through via with a large aspect ratio. Therefore, the semiconductor device may be miniaturized, and the electrical characteristics and reliability of the semiconductor device may be improved.

## Claims

1. A semiconductor device comprising:
a substrate (100) including active patterns (AP1, AP2);
a device isolation layer (ST) between the active patterns (AP1, AP2);
a stacked pattern (STP) on the substrate (100), wherein the stacked pattern (STP) includes active layers and sacrificial layers that are alternately stacked on the substrate (100);
a power transmission network layer (PDN) on a lower surface of the substrate (100);
a first through via (TVI1) penetrating the stacked pattern (STP); and
a second through via (TVI2) between the power transmission network layer (PDN) and the first through via (TVI1),
wherein the second through via (TVI2) penetrates the active patterns (AP1, AP2) and the device isolation layer (ST), and
wherein the first through via (TVI1) and the second through via (TVI2) are in contact with each other to form an interface therebetween.

2. The semiconductor device of claim 1, wherein the lower surface of the substrate (100) is coplanar with a lower surface of the device isolation layer (ST).

3. The semiconductor device of claim 1, further comprising separation structures (DB) on sides of the first through via (TVI1),
wherein each of the separation structures (DB) crosses the active patterns (AP1, AP2).

4. The semiconductor device of claim 1, wherein the interface is disposed between an upper surface (100U) and the lower surface (100L) of the substrate (100).

5. The semiconductor device of claim 1, wherein the first through via (TVI1) includes a first metal pattern (MP1) and a first barrier pattern (BP1) on a side surface of the first metal pattern (MP1),
wherein the second through via (TVI2) includes a second metal pattern (MP2) and a second barrier pattern (BP2) on a side surface of the second metal pattern (MP2).

6. The semiconductor device of claim 5, wherein the first barrier pattern (BP1) extends onto a lower surface of the first metal pattern (MP1),
wherein the second barrier pattern (BP2) extends onto an upper surface (100U) of the second metal pattern (MP2), and
wherein the first barrier pattern (BP1) and the second barrier pattern (BP2) are in contact with each other.

7. The semiconductor device of claim 5, wherein the first metal pattern (MP1) and the second metal pattern (MP2) include different metal materials from each other.

8. The semiconductor device of claim 5, wherein the second barrier pattern (BP2) extends onto an upper surface (100U) of the second metal pattern (MP2), and
wherein the second barrier pattern (BP2) is in contact with the first metal pattern (MP1).

## Patentansprüche

1. Halbleitervorrichtung, aufweisend:
ein Substrat (100) mit aktiven Mustern (AP1, AP2);
eine Vorrichtungsisolationsschicht (ST) zwischen den aktiven Mustern (AP1, AP2);
ein gestapeltes Muster (STP) auf dem Substrat (100), wobei das gestapelte Muster (STP) aktive Schichten und Opferschichten umfasst, die abwechselnd auf dem Substrat (100) gestapelt sind;
eine Leistungsübertragungs-Netzwerkschicht (PDN) auf einer unteren Oberfläche des Substrats (100);
eine erste Durchkontaktierung (TVI1), die das gestapelte Muster (STP) durchdringt; und
eine zweite Durchkontaktierung (TVI2) zwischen der Leistungsübertragungs-Netzwerkschicht (PDN) und der ersten Durchkontaktierung (TVI1),
wobei die zweite Durchkontaktierung (TVI2) die aktiven Muster (AP1, AP2) und die Vorrichtungsisolationsschicht (ST) durchdringt, und
wobei die erste Durchkontaktierung (TVI1) und die zweite Durchkontaktierung (TVI2) derart miteinander in Kontakt sind, dass sie eine Grenzfläche zwischen ihnen bilden.

2. Halbleitervorrichtung nach Anspruch 1, wobei die untere Oberfläche des Substrats (100) koplanar ist mit einer unteren Oberfläche der Vorrichtungsisolationsschicht (ST).

3. Halbleitervorrichtung nach Anspruch 1, das ferner Trennstrukturen (DB) an den Seiten der ersten Durchkontaktierung (TVI1) aufweist,
wobei jede der Trennstrukturen (DB) die aktiven Muster (AP1, AP2) kreuzt.

4. Halbleitervorrichtung nach Anspruch 1, wobei die Grenzfläche zwischen einer oberen Oberfläche (100U) und der unteren Oberfläche (100L) des Substrats (100) angeordnet ist.

5. Halbleitervorrichtung nach Anspruch 1, wobei die erste Durchkontaktierung (TVI1) ein erstes Metallmuster (MP1) und ein erstes Barrierenmuster (BP1) auf einer seitlichen Oberfläche des ersten Metallmusters (MP1) umfasst,
wobei die zweite Durchkontaktierung (TVI2) ein zweites Metallmuster (MP2) und ein zweites Barrierenmuster (BP2) auf einer seitlichen Oberfläche des zweiten Metallmusters (MP2) umfasst.

6. Halbleitervorrichtung nach Anspruch 5, wobei sich das erste Barrierenmuster (BP1) auf einer unteren Oberfläche des ersten Metallmusters (MP1) erstreckt,
wobei sich das zweite Barrierenmuster (BP2) auf einer oberen Oberfläche (100U) des zweiten Metallmusters (MP2) erstreckt und
wobei das erste Barrierenmuster (BP1) und das zweite Barrierenmuster (BP2) miteinander in Kontakt stehen.

7. Halbleitervorrichtung nach Anspruch 5, wobei das erste Metallmuster (MP1) und das zweite Metallmuster (MP2) voneinander unterschiedliche Metallmaterialien enthalten.

8. Halbleitervorrichtung nach Anspruch 5, wobei sich das zweite Barrierenmuster (BP2) auf einer oberen Oberfläche (100U) des zweiten Metallmusters (MP2) erstreckt und
wobei das zweite Barrierenmuster (BP2) mit dem ersten Metallmuster (MP1) in Kontakt steht.

## Revendications

1. Dispositif semi-conducteur comprenant :
un substrat (100) comprenant des motifs actifs (AP1, AP2) ;
une couche d'isolation de dispositif (ST) entre les motifs actifs (AP1, AP2) ;
une structure empilée (STP) sur le substrat (100), dans laquelle la structure empilée (STP) comprend des couches actives et des couches sacrificielles qui sont empilées alternativement sur le substrat (100) ;
une couche de réseau de distribution de puissance (PDN) sur une surface inférieure du substrat (100) ;
un premier via traversant (TVI1) pénétrant la structure empilée (STP) ; et
un deuxième via traversant (TVI2) entre la couche de réseau de distribution de puissance (PDN) et le premier via traversant (TVI1),
dans lequel le deuxième via traversant (TVI2) pénètre les motifs actifs (AP1, AP2) et la couche d'isolation de dispositif (ST), et
dans lequel le premier via traversant (TVI1) et le deuxième via traversant (TVI2) sont en contact l'un avec l'autre de sorte à former une interface entre ceux-ci.

2. Dispositif semi-conducteur selon la revendication 1, dans lequel la surface inférieure du substrat (100) est coplanaire avec une surface inférieure de la couche d'isolation de dispositif (ST).

3. Dispositif semi-conducteur selon la revendication 1, comprenant en outre des structures de séparation (DB) sur des côtés du premier via traversant (TVI1),
dans lequel chacune des structures de séparation (DB) croise les motifs actifs (AP1, AP2).

4. Dispositif semi-conducteur selon la revendication 1, dans lequel ladite interface est disposée entre une surface supérieure (100U) et la surface inférieure (100L) du substrat (100).

5. Dispositif semi-conducteur selon la revendication 1, dans lequel le premier via traversant (TVI1) comprend un premier motif métallique (MP1) et une première couche barrière (BP1) sur une surface latérale du premier motif métallique (MP1),
dans lequel le deuxième via traversant (TVI2) comprend un deuxième motif métallique (MP2) et une deuxième couche barrière (BP2) sur une surface latérale du deuxième motif métallique (MP2).

6. Dispositif semi-conducteur selon la revendication 5, dans lequel la première couche barrière (BP1) s'étend sur une surface inférieure du premier motif métallique (MP1),
dans lequel la deuxième couche barrière (BP2) s'étend sur une surface supérieure (100U) du deuxième motif métallique (MP2), et
dans lequel la première couche barrière (BP1) et la deuxième couche barrière (BP2) sont en contact l'une avec l'autre.

7. Dispositif semi-conducteur selon la revendication 5, dans lequel le premier motif métallique (MP1) et le deuxième motif métallique (MP2) comprennent des matériaux métalliques différents l'un de l'autre.

8. Dispositif semi-conducteur selon la revendication 5, dans lequel la deuxième couche barrière (BP2) s'étend sur une surface supérieure (100U) du deuxième motif métallique (MP2), et
dans lequel la deuxième couche barrière (BP2) est en contact avec le premier motif métallique (MP1).
